(19) Europäisches Patentamt
European Patent Office
Office européen des brevets

(11) EP 2 215 290 B1

(12) **EUROPEAN PATENT SPECIFICATION**

(45) Date of publication and mention of the grant of the patent:
**04.01.2012 Bulletin 2012/01**

(21) Application number: **08848771.5**

(22) Date of filing: **07.11.2008**

(51) Int Cl.:
***C30B 15/02*** *(2006.01)* ***C30B 29/06*** *(2006.01)*

(86) International application number:
**PCT/US2008/082838**

(87) International publication number:
**WO 2009/064674 (22.05.2009 Gazette 2009/21)**

(54) **REDUCTION OF AIR POCKETS IN SILICON CRYSTALS BY AVOIDING THE INTRODUCTION OF NEARLY INSOLUBLE GASES INTO THE MELT**

VERRINGERUNG VON LUFTTASCHEN IN SILICIUMKRISTALLEN DURCH VERMEIDUNG DES EINBRINGENS VON NAHEZU UNLÖSLICHEN GASEN IN DIE SCHMELZE

RÉDUCTION DES POCHES D'AIR DANS LES CRISTAUX DE SILICIUM EN ÉVITANT L'INTRODUCTION DE GAZ PRESQUE INSOLUBLE DANS LE BAIN DE FUSION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **13.11.2007 US 939393**

(43) Date of publication of application:
**11.08.2010 Bulletin 2010/32**

(73) Proprietor: **MEMC Electronic Materials, Inc.**
**St. Peters, MO 63376 (US)**

(72) Inventors:
- **KORB, Harold, W.**
  **Chesterfield, Missouri 63017 (US)**
- **PHILLIPS, Richard**
  **St. Peters, Missouri 63376-5000 (US)**

(74) Representative: **Maiwald Patentanwalts GmbH**
**Elisenhof**
**Elisenstrasse 3**
**80335 München (DE)**

(56) References cited:
**WO-A-2004/005591**
**US-A- 5 242 531**
**US-A- 5 588 993**
**US-A1- 2003 101 924**
**US-B1- 6 344 083**
**US-B1- 6 350 312**
**US-B2- 6 461 427**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### FIELD OF THE INVENTION

The present invention relates to a method for reducing the amount of insoluble gas carried into a silicon melt by a charge of granular polycrystalline silicon.

### BACKGROUND OF THE INVENTION

In the production of single crystal silicon ingots grown by the Czochralski method, polycrystalline silicon in the form of granular polycrystalline silicon, chunk polycrystalline silicon, or a mixture of chunk and granular polycrystalline silicon is first melted down within a quartz crucible and equilibrated to a temperature of about 1500°C. Chunk polycrystalline silicon is a polycrystalline silicon mass which is generally irregular in shape, with sharp, jagged edges as a result of the fact that it is prepared by breaking rods of polycrystalline silicon into smaller pieces. Chunk polycrystalline silicon typically ranges from about 2 centimeters to about 10 centimeters in length and from about 4 centimeters to about 6 centimeters in width. Polycrystalline silicon granules are particles that are less dense than chunk polycrystalline silicon and are typically characterized by irregular surfaces, cracks, and voids. Polycrystalline silicon granules typically range from about 0.2 mm to about 2 millimeters in diameter and generally have a packing density which is about 20% higher than chunk polycrystalline silicon.

In a conventional melt preparation, as the polycrystalline silicon is heated and melted, an inert purge gas such as argon is continuously introduced over the crucible and silicon to remove unwanted contaminants from the melt area that are produced in and around the melt during the melting of the polycrystalline silicon. After the silicon has completely melted and reached a temperature of about 1500°C, a seed crystal is dipped into the melt and subsequently extracted while the crucible is rotated to form a single crystal silicon ingot. During the early stages of the melting process when the polycrystalline charge is completely or partially in the solid state, the argon purge gas may become trapped in the polycrystalline silicon charge and may become incorporated into the silicon melt, thereby increasing the risk that the trapped argon may form air pockets of various sizes in the growing silicon single crystal ingot as air pockets.

In U.S. 6,344,083 and WO 2004/005591 Holder proposed a solution to the problem of incorporating argon and other insoluble gases into the silicon melt. Holder's method involved purging the crystal pulling apparatus with an ambient comprising a significant portion of soluble gas, such as nitrogen or hydrogen. While helpful in removing insoluble gases from the silicon melt, surrounding the melt with a nitrogen-containing ambient may undesirably increase the amount of nitrogen that becomes incorporated into the melt and the growing crystal ingot.

### SUMMARY OF THE INVENTION

Among the various aspects of the present invention may be noted the provision of a method for controlling and thereby reducing the amount of insoluble gas carried into a silicon melt by a charge of granular polycrystalline silicon. A silicon melt prepared with such a charge of granular polycrystalline silicon has a low level of insoluble gas, which thereby leads to a reduction of defects, such as air pockets, in a single crystal ingot grown therefrom.

Briefly, the present invention is directed to a process for controlling the amount of insoluble gas carried by a charge of granular polycrystalline silicon. The process comprises (i) charging a feeding container with granular polycrystalline silicon, (ii) forming an ambient atmosphere in the feeding container, the ambient atmosphere having a mole fraction of at least 0.9 of a gas having a solubility in molten silicon of at least about $5 \times 10^{13}$ atoms/$cm^3$ at a temperature near the melting point of silicon and at a pressure of about 1 bar (about 100 kPa), and (iii) reducing the pressure inside the charged feeding container.

The present invention is further directed to a process for preparing a silicon melt in a crucible in a growth chamber of a crystal puller apparatus. The process comprises feeding an initial charge of polycrystalline silicon to the crucible residing in the growth chamber of the crystal puller apparatus and melting a fraction of the initial charge to thereby form a partially melted charge; holding granular polycrystalline silicon in a feeding container having an ambient atmosphere as the initial charge is being melted, the ambient atmosphere having a mole fraction of at least 0.9 of a gas having a solubility in molten silicon of at least about $5 \times 10^{3}$ atoms/$cm^3$ at a temperature near the melting point of silicon and at a pressure of about 1 bar (about 100 kPa); and feeding the held granular polycrystalline silicon to the crucible to supplement the initial charge, and melting the supplemental charge of granular polycrystalline silicon to form the silicon melt in the crucible.

Other objects and features will be in part apparent and in part pointed out hereinafter.

## BRIEF DESCRIPTION OF THE DRAWINGS

FIG. 1 is a photograph (1000x magnification) of a polished cross-section of a granule.

FIG. 2 is a graph correlating bubble radius with number of argon atoms in a bubble.

FIG. 3 is a graph correlating terminal velocity of a bubble with bubble radius.

FIG. 4 is a graph correlating internal bubble pressure with bubble radius.

FIG. 5 is a graph depicting theoretical equilibrium conditions for argon bubbles in a silicon melt under a defined set of conditions.

FIG. 6 is a graph depicting the behavior of small argon bubbles in a silicon melt.

FIG. 7 is a graph depicting the behavior of small argon bubbles in a silicon melt.

FIG. 8 is a graph depicting the behavior of large argon bubbles in a silicon melt.

FIG. 9 is a graph depicting the behavior of intermediate argon bubbles in a silicon melt.

FIG. 10 is a graph depicting the behavior of intermediate argon bubbles in a silicon melt in a silicon melt having 10 ppma of SiO.

FIG. 11 is a graph depicting the behavior of intermediate argon bubbles in a silicon melt in a silicon melt having 10 ppma of SiO and 10 ppma hydrogen.

FIG. 12 is a graph illustrating theoretical equilibrium concentrations of nitrogen and argon with the puller ambient under a defined set of conditions.

FIG. 13 is an illustration of a feeding container for feeding granular polycrystalline silicon to a crucible in a crystal puller apparatus.

FIG. 14 is a bar chart depicted the % of a population of wafers characterized by wafer defects. The wafers were obtained from ingots grown according to the methods described in the Example.

Corresponding reference characters indicate corresponding parts throughout the drawings.

## DESCRIPTION OF THE EMBODIMENT(S) OF THE INVENTION

In accordance with one aspect of the present invention, a method is provided for controlling the amount of insoluble gas carried into a silicon melt by a charge of granular polycrystalline silicon. Argon and other insoluble gases that may be present on the surfaces of and trapped in the cracks and voids of the polycrystalline silicon granules are sources of insoluble gas in the silicon melt. These sources of insoluble gas may be more problematic than argon purge gas in the growth chamber because the granules directly carry argon and other insoluble gases into the melt. For example, a charge of granular polycrystalline silicon is capable of supersaturating a melt with argon. Argon's solubility in silicon is estimated to be about 0.1 ppb (about $5x10^{12}$ atoms/$cm^3$) at a temperature near the melting point of silicon, e.g. at or slightly above about 1420°C and below about 1450°C, and at a pressure of about 1 bar (about 100 kPa). Granular polycrystalline silicon may carry enough argon to incorporate up to 10 ppb (about $5x10^{14}$ atoms/$cm^3$) in the silicon melt, a concentration that may cause nucleation of bubbles at nucleation centers, such as the crucible wall, and spontaneous nucleation in the bulk of the melt.

According to the method of the present invention, granular polycrystalline silicon, prior to feeding into a growth chamber in a crystal pulling apparatus, is loaded into a feeding container, and an ambient atmosphere is formed in the feeding container, the ambient atmosphere having a mole fraction of at least 0.9 of a gas having a solubility in molten silicon of at least about $5x10^{13}$ atoms/$cm^3$ at a temperature near the melting point of silicon and at a pressure of about 1 bar (about 100 kPa). Preferably, the ambient atmosphere formed in the feeding container has a mole fraction of at least 0.95 of the soluble gas, more preferably, the mole fraction is at least about 0.97, at least about 0.99, at least about 0.999, or even at least about 0.9999. The mole fraction of soluble gas in the ambient atmosphere formed in the feeding container may be as high as 0.99999. By forming the ambient atmosphere in the feeding container prior to feeding the granules to the growth chamber, a significant portion of argon and other insoluble gas may be removed from the polycrystalline silicon granules.

In the context of the present invention, an insoluble gas has solubility of less than about $5x10^{13}$ atoms/$cm^3$ in molten silicon at a temperature near the melting point of silicon, e.g. at or slightly above about 1420°C at a pressure of about 1 bar (about 100 kPa). Gases having solubility at or below this threshold include argon and, generally, the noble gases, such as helium, neon, krypton, and xenon. Conversely, a soluble gas has solubility of greater than about $5x10^{13}$ atoms/$cm^3$ in molten silicon at a temperature near the melting point of silicon and at a pressure of about 1 bar (about 100 kPa). Soluble gases include nitrogen, hydrogen, chlorine, hydrogen chloride, and ammonia.

### I. Characteristics of Insoluble Gas Bubbles

In general, insoluble gas bubbles, if present in the silicon melt, may cause the formation of air pockets in the growing single crystal silicon ingot. At least two mechanisms for the formation of insoluble gas bubbles in a silicon melt may be proposed: (1) nucleation of bubbles at the crucible wall and (2) spontaneous nucleation in the bulk of the silicon melt.

With regard to the first mechanism, the crucible in which the silicon is charged typically comprises surface roughness, such as divots, voids, and cracks, which are capable of nucleating $SiO_x$ bubbles at various points along the crucible surface, these bubbles being capable of collecting insoluble gas in the melt, thereby forming stable, insoluble gas bubbles that remain after the $SiO_x$ dissolves. Moreover, the crucible may contain trapped $SiO_x$ bubbles within its surface. These $SiO_x$ bubbles will be exposed to the melt as molten silicon dissolves the interior crucible wall and, once exposed, may also nucleate bubbles capable of collecting insoluble gas from the melt.

With regard to the second mechanism, argon or insoluble gas may, if present in a silicon melt at high concentrations, spontaneously nucleate stable bubbles in the melt. The likely source of spontaneous nucleation of bubbles in the melt is argon or other insoluble gas bubbles trapped on the surface of and in the crevices and cracks of the granular polycrystalline silicon, wherein the argon bubbles from the granule itself coalesce and form bubbles in the silicon melt as the granule dissolves. See FIG. 1, which is a photograph (1000x magnification) of a polished cross-section of a granule. Surface roughness therein is indicative of trapped argon bubbles that may become nucleation centers in the silicon melt.

Bubbles containing argon or other insoluble gas in a silicon melt may be generally classified into three sizes: small, intermediate, and large. A bubble may be characterized as "small" if the radius of the bubble is less than the critical radius and the bubble is susceptible to dissolving in the melt before being carried into the growing single crystal ingot by the flow of molten silicon. The critical radius generally depends upon silicon melt conditions, such as the concentration of insoluble gas in the melt, melt temperature, and the equilibrium behavior of the insoluble gas in the silicon melt and with the ambient. Generally, a bubble is "small" if its radius is less than one micrometer. As stated above, argon and other equivalently insoluble gases are generally sparingly soluble, and thus bubbles, if small enough, may dissolve into the melt in a relatively short period of time. A bubble may be characterized as "large" if the radius is much greater than the critical radius and is large enough to render the bubble relatively buoyant in the melt. Generally, "large" bubbles have a radius greater than 250 micrometers and may be buoyant enough to escape to the melt surface in a relatively short period of time. Finally, a bubble may be characterized as "intermediate" if the radius is greater than the critical radius, but is not so large to render the bubble buoyant in the silicon melt. Generally, an "intermediate" bubble has a radius between about 2 micrometers and about 100 micrometers, such as about 10 micrometers to about 50 micrometers. These bubbles are neither likely to dissolve in the melt in a short period of time or to rapidly float to the melt surface and escape from the silicon melt. Therefore, the "intermediate" bubbles, which may be long lived in the silicon melt, are most likely to become entrained in and form air pockets in the growing single crystal silicon ingot.

The size of a bubble depends directly on the number of argon atoms in the bubble. FIG. 2 is a graph depicting the relationship between the number of argon atoms in a bubble and the bubble’s radius, for a standard set of crystal puller conditions (puller ambient pressure of 20 Torr and melt depth of 20 cm, at 1803 K). The range of $1x10^6$ to $1x10^{14}$ argon atoms per bubble, which covers bubble radii (in micrometers) from about 0.1 micrometers to about 500 micrometers, is the range of practical interest.

With regard to buoyancy, it is possible to estimate a bubble radius above which nearly all insoluble gas bubbles are buoyant and will therefore float to the melt surface or the crystal interface and escape from the silicon melt in a relatively short period of time. It has been observed that the terminal floating velocity depends on the size of the bubble. On the one hand, large, buoyant bubbles may simply float upward to the surface relatively quickly, while small radius bubbles may follow the melt flow until they reach the surface by random chance. In any case, the concentration of bubbles decays exponentially with time due to escape from the melt. A simple model for estimating the bubble decay rate takes into account the lateral velocity at the melt surface, the escape of bubbles that begin relatively near the melt surface, and reasonable values for the terminal velocities of bubbles deep in the silicon melt. This estimate, along with the terminal velocity, is shown in FIG. 3. In view of the estimated terminal velocities, it is observed that bubbles having a radius greater than about 100 micrometers have high terminal velocity and float to the surface relatively quickly. Bubbles having radii of only a few micrometers will remain in the melt for long time. The terminal velocity of small bubbles is estimated to be less than typical melt flow velocities, so these would simply follow the melt flow until random variation may bring them near the melt surface to escape.

With regard to the dissolution rate of the bubbles, it is thought that the time necessary for a bubble to dissolve depends, in part, on the internal surface pressure of the bubble. Because of the high surface tension of liquid silicon (about 730 $erg/cm^2$), the pressure in a small bubble is relatively high. The pressure as a function of bubble radius is illustrated in FIG. 4. Bubbles having a radius of about 1 micrometer have internal pressure greater than 10 bars, while bubbles having a 1 mm radius have pressure comparable to the ambient pressure in the puller. The high pressures of small bubbles promote their dissolution into the silicon melt.

Bubble dissolution rates may be estimated. For a bubble that is formed in the melt during silicon melting, the time ($t_{dissolve}$) necessary for the bubble to dissolve is proportional to $N_{Ar}$ / $C^*_{Ar}$ (wherein $N_{Ar}$ = number of argon atoms per bubble and $C^*_{Ar}$ = saturated concentration of argon in the melt). For example, a bubble with a radius of 5 micrometers

and $C^*_{Ar}$ = 5x10$^{13}$ atoms/cm$^3$ (characteristic of a soluble gas) is estimated to dissolve in 453 seconds. This is an acceptable duration, particularly if the bubble formed during feeding. A bubble having a radius of about 20 micrometers and $C^*_{Ar}$ = 5x10$^{13}$ atoms/cm$^3$, however, would take 16 times as long, or about 2 hours. To ensure that these bubbles have a sufficient amount of time to dissolve, it may be necessary to heat the silicon melt for at least two hours, or more, which impairs the throughput of the method but could still be acceptable. On the other hand, a bubble with a radius of 5 micrometers and $C^*_{Ar}$ = 5x10$^{12}$ atoms/cm$^3$ (characteristic of an insoluble gas) is estimated to require 4,730 seconds, or 1.3 hours to dissolve, and a bubble with radius of about 20 micrometers and $C^*_{Ar}$ = 5x10$^{12}$ atoms/cm$^3$ would take over 20 hours to dissolve, which is an unacceptable duration for commercial practicality.

With regard to bubbles that nucleate at the crucible surface (which may occur at any time in a saturated melt, even during crystal growth), these bubbles contain mostly $SiO_x$ but may collect a significant portion of argon which diffuses into the bubble while it is growing large enough to escape from the crucible surface. The amount of argon in the bubble ($N_{Ar}$) in this case is proportional to $C_{Ar}$ ($C_{Ar}$ = concentration of argon in the melt) in the melt. When the bubble leaves the crucible surface, the radius may decrease below the critical size r*, since the lower concentration of $SiO_x$ in the bulk of the melt is lower than at the surface, and some of the $SiO_x$ dissolves in the melt. The bubble collapses, since the $SiO_x$ thermodynamics dominate, but once it collapses down to its argon "core" it has become an argon bubble with the same problem of slow dissolution. The number of argon atoms, $N_{Ar}$, is proportional to $C_{Ar}$, and the dissolution time is proportional to $N_{Ar} / C^*_{Ar}$, so now $t_{dissolve} \sim C_{Ar} / C^*_{Ar}$. To first order, $C_{Ar}$ doesn't depend upon $C^*_{Ar}$ directly, but depends only upon the amount of argon dragged into the melt. If a bubble nucleates and grows while silicon single crystal growth is underway, there may not be sufficient time for even smaller bubbles (about 5 micrometers) to dissolve, since such bubbles may flow to the crystal interface before they dissolve.

In view of the above considerations of the relative buoyancy of large bubbles and the dissolution of small bubbles, it is thought that there is a range of bubble radii within which the bubbles are neither buoyant enough to rapidly float to the melt surface nor small enough to rapidly dissolve. Accordingly, bubbles of insoluble gas having a size greater than a critical radius survive in a melt (i.e., do not dissolve), but also may not float to the surface.

II. Granular Polycrystalline Silicon as a Source of Insoluble Gas in a Silicon Melt

Since the problem may be considered in terms of bubble size, which is directly related to the concentration of insoluble gases in the melt, it is worthwhile to consider sources of insoluble gases in the silicon melt. Sources of argon in the silicon melt include the puller ambient (conventionally, 100% Ar, at fairly low pressure such as 20 Torr (about 2.7 kPa)) and the granular polycrystalline silicon. The following table may be used to estimate the amount of argon that may be carried into a silicon melt from the granular polycrystalline silicon under a standard set of conditions.

Table I.

| | |
|---|---|
| Massfed | 2.0x10$^2$ |
| Massmelt | 2.5x10$^2$ |
| NBB | 1.3x10$^9$ |
| BBdensity | 1.3x10$^4$ |
| CArMelt | 7.9x10$^{13}$ |
| ArBubbleDensity | 1.2x10$^9$ |
| NArPerBubble | 6.7x10$^4$ |
| ArRipen | 1x10$^4$ |
| ArBubbleDensityRipened | 1.2x10$^5$ |
| NArPerBubbleRipened | 6.7x10$^8$ |

In the above Table I, Massfed is the mass of granules fed in kg; Massmelt is the total mass of the silicon melt in kg; NBB is an estimate of the number of granules fed into the melt; BBdensity is the average concentration of granules fed into the melt per cm$^3$; CArMelt is the total argon concentration in the melt provided by the granules in atoms/cm$^3$; ArBubbleDensity is the potential number of argon bubbles per cm$^3$ of melt if all voids in granule surface remained separate; NArPerBubble is the number of argon atoms per bubble if all voids in the granule surface remained separate; ArRipen is a theoretical number of bubbles assumed to combine into larger bubbles; ArBubbleDensityRipened is the number of argon bubbles per cm$^3$ of melt if original voids consolidate into fewer bubbles; and NArPerBubbleRipened is the number of argon atoms per bubble if original voids consolidate into fewer bubbles.

Based on the above table, a charge of granular polycrystalline silicon carries a significant amount of argon into a silicon melt. The total number of argon atoms carried in by the granules is estimated to be about 7.9x10$^{13}$ atoms/cm$^3$, divided among as many as 1.2x10$^9$ bubbles. A certain fraction of these bubbles will nucleate into larger, "ripened" bubbles, which may be buoyant enough to escape from the melt and lower the melt argon concentration. In this case, the assumption was that about $1x10^4$ bubbles would ripen into large bubbles, each large bubble having about $1x10^4$ as many argon atoms as the bubbles that are assume not to ripen. Recall that argon's solubility in silicon is estimated to be about 0.1 ppb (about $5x10^{12}$ atoms/$cm^3$) in molten silicon at about 1 bar (about 100 kPa). The estimated argon concentration carried in by the granules is therefore greater than 10x the solubility of argon in molten silicon. Moreover, this concentration is much larger than the concentration of argon atoms expected in a silicon melt in equilibrium with an argon ambient.

Since argon has some solubility in a silicon melt (such that some of the bubbles dissolve in the melt) and since some the bubbles may ripen into large bubbles that will escape from the silicon melt, it is possible to estimate the concentration of argon in the silicon melt at equilibrium and estimate the number and size of the bubbles that will neither dissolve nor escape from the melt and may thus become entrained in and form air pockets in the growing single crystal silicon ingot.

In a conventional process, the puller ambient is argon, which may be a source of argon in the melt due to equilibration with the ambient. With reference now to FIG. 5, the equilibrium argon concentration and bubble properties under a defined set of conditions are shown. In FIG. 5, the range of argon concentrations considered is expressed as a multiple of the concentration which would be in equilibrium with the ambient at a typical temperature and pressure (Temperature = 1700K, Pressure = 20 Torr, and a melt depth of 5 cm). If the argon concentration carried into the melt by granules is about $7.9x10^{13}$ atoms/$cm^3$ (based on the estimates in Table I), as further explained below, any bubble with fewer than $3x10^8$ atoms, i.e., smaller than 1 micrometer in radius, will be sub-critical and will dissolve, which will tend to increase the argon concentration in the silicon melt. On the other hand, if the argon concentration in the melt is $6x10^{12}$ atoms/$cm^3$, any bubble with more than $1x10^{11}$ argon atoms and having a radius of about 20 micrometers will be supercritical. The supercritical bubbles will grow, which will tend to decrease the argon concentration in the melt. Some of the supercritical bubbles will be buoyant enough to escape from the melt. Equilibrium is therefore predicated on balancing the factors which tend to increase the argon concentration in the melt (dissolved bubbles and argon from the puller ambient) with factors which tend to decrease the argon concentration in the melt (growing bubbles and the escape of buoyant bubbles into the ambient). The equilibrium argon concentration affects the behavior of, and allows predictions of that behavior of all bubbles -- small, intermediate, and large -- in the silicon melt.

With reference now to FIG. 6, the behavior of small bubbles in the melt is illustrated. Suppose the amount of dissolved argon is very small (say $1x10^8$ atoms/$cm^3$) and the melt contained $2.4x10^6$ small bubbles/$cm^3$ containing $3.3x10^7$ argon atoms each. These bubbles would dissolve in less than 30 seconds, which would raise the melt argon concentration to about $7.9x10^{13}$ atoms/$cm^3$. Fewer of these small bubbles would dissolve even faster. If the number of small bubbles is reduced by a factor of $1x10^4$ the bubbles would dissolve in 23 seconds, and the argon concentration would increase by only about $8x10^9$ atoms/$cm^3$. These bubbles are smaller than 0.5 micrometers, so according to FIG. 3, they would take many hours to escape randomly from the melt, but they would dissolve quickly. With reference now to FIG. 7, the behavior of bubbles containing about $3.3x10^8$ atoms/bubble is illustrated. If there are $2.5x10^5$ of these bubbles per $cm^3$, there is still a total of $7.9x10^{13}$ argon atoms/$cm^3$, as in the case illustrated in FIG. 6. These bubbles are about 1.12 micrometers in size so they would escape from the melt only after about 50 hours (3 time constants) according to FIG. 3, but these bubbles will dissolve in about 6 minutes.

For bubbles having about $1.1x10^{11}$ argon atoms/bubble, the initial radius is about 20 micrometers, which is though to be supercritical (stable) for argon concentrations greater than about $3x10^{12}$ argon atoms/$cm^3$. The behavior of these bubbles at a concentration of $7.2x10^2$ bubbles/$cm^3$ is illustrated in FIG. 8. Initially, the background argon concentration ($C_{Ar}$) is assumed to be very low, and the bubbles dissolve until $C_{Ar}$ increases to the equilibrium concentration, and bubble shrinkage nearly stops. A state of quasi equilibrium is established. The bubbles eventually dissolve after 31 hours because the total background argon concentration decreases by evaporation from the melt. However, since the radius is about 20 micrometers, the time constant for random escape is expected to be low, and is about 150 seconds, according to FIG. 3.

The above discussion has focused on bubbles having sizes ranging from very low (which would be expected to rapidly dissolve) to very high (which would be buoyant enough to escape from the melt). Intermediate bubbles may contain about $6.6x10^9$ argon atoms per bubble, which is about the number of argon atoms in a typical polycrystalline granule. Such bubbles have a radius of about 5.0 micrometers. According to FIG. 9, such bubbles would take about $1.1x10^4$ seconds (more than 3 hours) to dissolve. With regard to the time constant needed to escape, the melt may contain about $1.2x10^4$ of these bubbles per $cm^3$. To decrease the density $1.2x10^4$ of these bubbles per $cm^3$ to about 1 bubble per $cm^3$ would take about 9.4 time constants, and as shown in FIG. 3, this is about 6 hours. Since it would take longer than 3 hours to dissolve these bubbles or 6 hours to allow them to escape randomly, unless throughput were not a consideration, some of these intermediate bubbles would likely reach the growing crystal interface and become air pockets in the growing single crystal silicon ingot.

If, however, the number of 5-micrometer bubbles were reduced by a factor of 10 (and the total argon therefore is also reduced by a factor of 10), the dissolution time would drop to $5.0x10^3$ seconds (about 1.4 hours) since the dissolution of these bubbles would not so greatly increase the argon concentration in the melt (only to about $4.0 \times 10^{12}$ atoms/$cm^3$, which is approximately equal to the solubility of argon in the silicon melt at 1 bar).

On the other hand, if the number of 5-micrometer bubbles were increased by a factor of 10 (and the total argon therefore is also increased by a factor of 10), the bubbles never dissolve (until the overall argon concentration drops via surface evaporation). Even if the large argon concentration were distributed among smaller bubbles (1.6 micrometers), the bubbles still would not dissolve because of the high background argon concentration in the melt. Based on the above, it is apparent that not only is there a "sour spot" for bubble size, but there is also an upper limit of tolerable total argon concentration.

III. Influence of Soluble Gas in a Silicon Melt

Thus far, the behavior of argon has been considered as if it were the only gas in the silicon melt. The silicon melt would be expected to have other gases therein, such as $SiO_x$ and hydrogen. FIG. 10 depicts the behavior of argon bubbles containing about $6.6 \times 10^9$ argon atoms per bubble (about 5.0 micrometer radius) in a silicon melt having 10 ppma of $SiO_x$ (or O). In this case, the bubbles rapidly equilibrate to a slightly larger size, as shown in FIG. 10, since each bubble quickly captures about $1 \times 10^9$ $SiO_x$ molecules from the melt.

If $SiO_x$ and hydrogen (a soluble gas) are both present in the melt at 10 ppma, the bubbles grow rapidly by collecting both $SiO_x$ and hydrogen molecules, as shown in FIG. 11. The solubility of hydrogen in the melt is about 1 ppma, so a concentration of 10 ppma (substantially above the solubility of hydrogen) would allow about $2 \times 10^{13}$ hydrogen molecules to be collected in each bubble. The bubbles would quickly grow to 200 micrometer radius, and would grow even larger by collecting SiO. These bubbles should escape quickly. The hydrogen content in the bubbles levels off because a finite amount of H is available to exchange between the bubbles and the melt. The same is not true for SiO, which is assumed to have an unlimited supply.

The solubility of nitrogen in molten silicon is estimated to be about 100 ppma. Assume that instead of carrying argon into the melt the granular polycrystalline silicon carried $N_2$ molecules instead. Using the values in Table I, that would suggest that about $1.6 \times 10^{14}$ nitrogen atoms/$cm^3$ would be carried into the melt if all of the $N_2$ were dissolved. FIG. 12 illustrates the properties of bubbles that could exist in equilibrium with that background, for $C_H$=0, $C_{SiO}$=0, and $C_{Ar}$=$1.3 \times 10^{11}$ atoms/$cm^3$ (this value of $C_{Ar}$ would be in equilibrium with the puller ambient). This value of background N, $1.6 \times 10^{14}$ atoms/$cm^3$, is essentially 0 on the plot, showing that no stable bubbles should exist. All bubbles would be subcritical and would dissolve.

IV. Method of Treating Granular Polycrystalline Silicon to Remove Insoluble Gas

In general, replacement of argon and other insoluble gases on the surfaces of or in the cracks of granular polycrystalline silicon with a soluble gas such as nitrogen, hydrogen, chlorine, hydrogen chloride, ammonia and combinations thereof may substantially reduce and even eliminate a source of stable bubbles in the silicon melt, which, in turn, may reduce air pockets in a growing silicon crystal ingot. Accordingly, one aspect of the present invention is directed to a method of reducing the amount of argon and other insoluble gases which may be carried by a charge of granular polycrystalline silicon. The method comprises three steps: (a) charging a feeding container with granular polycrystalline silicon, (b) forming an ambient atmosphere in the feeding container, the ambient atmosphere having a mole fraction of at least 0.9 of a gas having a solubility in molten silicon of at least about $5 \times 10^{13}$ atoms/$cm^3$ at a temperature near the melting point of silicon and at a pressure of about 1 bar (about 100 kPa), and (c) reducing the pressure inside the charged feeding container. Steps (a) and (b) may be carried out in any order, but step (c) is carried out after step (a). For example, steps (a), (b), and (c) are carried out in that order. Alternatively, step (b) may be carried out before step (a), which is followed by step (c). Alternatively, step (a) may be carried out before step (c), which is followed by step (b). In some embodiments, at least one of steps (b) and (c) are carried out more than once, i.e., at least twice, three times, or more.

The gas used to form the ambient atmosphere in the feeding container has a solubility in molten silicon of at least about $5 \times 10^{13}$ atoms/$cm^3$ at a temperature near the melting point of silicon, e.g. at or slightly above about 1420°C and below about 1450°C, and at a pressure of about 1 bar (about 100 kPa). Preferably, the gas has a solubility in molten silicon of at least about $1 \times 10^{14}$ atoms/$cm^3$, more preferably at least about $1 \times 10^{15}$ atoms/$cm^3$, still more preferably at least about $1 \times 10^{16}$ atoms/$cm^3$, still more preferably at least about $1 \times 10^{17}$ atoms/$cm^3$, and even more preferably at least about $6 \times 10^{18}$ atoms/$cm^3$. Such gases include nitrogen, hydrogen, chlorine, hydrogen chloride, and ammonia. Combinations of these gases may be used, such as a combination of nitrogen and hydrogen. Nitrogen alone is particularly preferred. The source gas preferably has a purity of at least about 99%, more preferably at least about 99.9%, and most preferably at least about 99.99%.

The ambient atmosphere formed in the feeding container has a mole fraction of at least 0.9 of a gas having a solubility in molten silicon of at least about $5 \times 10^{13}$ atoms/$cm^3$ at a temperature near the melting point of silicon and at a pressure of about 1 bar (about 100 kPa). Preferably the mole fraction is at least about 0.95, even more preferably the mole fraction is at least about 0.97, such as at least about 0.98, at least about 0.99. In some embodiments, substantially the entire ambient atmosphere in the feeding container comprises soluble gas, i.e., the mole fraction is at least about 0.999, at least about 0.9999, or even at least about 0.99999.

Preferably, the granular polycrystalline silicon is exposed to the soluble gas at relatively high pressure to enhance the removal of insoluble gases and the adsorption of the soluble gas on the surface of the granules and in the cracks and crevices. Accordingly, the ambient atmosphere in the feeding container is formed by introducing soluble gas to an ambient pressure in the feeding container between about 10 Torr (about 1.3 kPa) and about 1 atm (about 101.3 kPa), such as between about 10 Torr (about 1.3 kPa) and about 100 Torr (about 13.3 kPa). Moreover, the ambient atmosphere in the feeding container is preferably held at such pressures for a duration sufficient to cause the adsorption of a substantial quantity of soluble gas on the surface of and in the cracks and crevices of the granules. Although the duration in which the ambient atmosphere is held at such pressures may be indefinite, i.e., such as longer than 1 hour, 2 hours, 5 hours, 10 hours, 20 hours, or more, a substantial quantity of soluble gas may be adsorbed by the granules in a duration as short as about 10 seconds, such as between about 10 seconds and about 100 seconds. Preferably, the duration is at least about 15 seconds, at least about 30 seconds, or at least about 1 minute, 2 minutes, 5 minutes, up to about 60 minutes, such as between about 15 seconds and about 60 minutes.

The process of the present invention further includes reducing the pressure inside the feeding container. A pressure cycle comprising forming the ambient atmosphere in the feeding container followed by or preceded by reducing the pressure inside feeding container achieves several prominent advantages. Among them, pressure reduction removes a substantial portion of the insoluble gas, water, and other impurities present on the surface of or trapped in the cracks and crevices of the granules. To effect adequate removal of water, insoluble gas, and other impurities, the pressure inside the feeding container may be reduced to below about 50 Torr (about 6.7 kPa), more preferably below about 20 Torr (about 2.7 kPa), even more preferably between about 0 Torr and about 10 Torr (about 1.3 kPa), still more preferably between about 0 Torr and about 5 Torr (about 0.7 kPa), and still more preferably between about 0 Torr and about 2 Torr (about 0.3 kPa). Although the pressure inside the feeding container may be reduced indefinitely, i.e., longer than 1 hour, 2 hours, 5 hours, 10 hours, 20 hours, or more, durations as short as about 10 seconds removes a substantial portion of water, insoluble gas, and other impurities from the granules. At least about 15 seconds, at least about 30 seconds, or at least about 1 minute, 2 minutes, 5 minutes, 60 minutes or more of reduced pressure are preferred. In one embodiment, the pressure may be reduced in the feeding container for durations between about 15 seconds and about 60 minutes. The duration of pressure reduction is preferably sufficient to remove at least about 50% of the insoluble gas present on the surface of or in the cracks and crevices of the granules, preferably at least about 90% of the insoluble gas, more preferably at least about 95% of the insoluble gas, still more preferably at least about 99% of the insoluble gas, still more preferably at least about 99.9% of the insoluble gas, such as at least about 99.99% of the insoluble gas.

Prior to feeding a charge of granular polycrystalline silicon to a growth chamber of a crystal puller apparatus in the preparation of a silicon melt, the pressure is preferably reduced to be substantially equal to that of the growth chamber. In general, the growth chamber is kept at low pressure during silicon melt preparation, such as below about 100 Torr (about 13.3 kPa), more typically below about 50 Torr (about 6.7 kPa), more typically between about 10 Torr (about 1.3 kPa) and about 40 Torr (about 5.3 kPa), such as about 20 Torr (about 2.7 kPa). In some embodiments, the pressure inside the growth chamber of the crystal pulling apparatus during granular feeding is higher, such as between about 100 Torr (about 13.3 kPa) and 760 Torr (about 101.3 kPa), or between about 100 Torr (about 13.3 kPa) and about 400 Torr (about 53.3 kPa). Again, the pressure inside the feeding container during granular polycrystalline feeding is preferably substantially equivalent to that of the crystal pulling apparatus during granular feeding.

FIG. 13 is an illustration of a feeding container that may be used for feeding granular polycrystalline silicon to a crucible in a crystal puller apparatus. The feeding container is generally hopper 100 equipped with granular feeding tube 102, which is an inlet for granular polycrystalline silicon. The fill tube 102 is further equipped with valve 104. The hopper 100 also includes gas inlet 106, which is equipped with valve 108. Gas inlet 106 is both a source of soluble gas ambient and an exhaust for removing ambient from hopper 100. At the opposite end of hopper 100 from fill tube 102 is feeding nozzle 110, equipped with metering device 112. Feeding nozzle 110 provides the means for feeding granular polycrystalline from the hopper and into the growth chamber of a crystal pulling apparatus (not shown), while metering device 112 regulates the flow rate of granular-polycrystalline silicon from hopper 100, typically by using a rotating disk that may be moved toward (closed) hopper 100 to restrict flow and moved away from hopper 100 (open) to permit flow. The rotating disk comprises one or more apertures, whereby rotation of the rotating disk effects intermittent feeding of the granules through feeding nozzle 110. Alternatively, an aperture of rotating disk may be permanently aligned with feeding nozzle 110 during feeding to effect continuous granular flow. Feeding nozzle 110 is also equipped with a valve (not shown), such that feeding nozzle 110 is both a source of soluble gas ambient and an exhaust for removing ambient from hopper 100.

In one embodiment, a feeding container is charged with granular polycrystalline silicon; the ambient atmosphere is formed in the charged feeding container by introducing a gas having a solubility in molten silicon of at least about $5x10^{13}$ atoms/cm$^3$ at a temperature near the melting point of silicon and at a pressure of about 1 bar (about 100 kPa) into the charged feeding container to form the ambient atmosphere, the ambient atmosphere having a mole fraction of at least 0.9 of a gas having a solubility in molten silicon of at least about 5x$10^{13}$ atoms/$cm^3$ at a temperature near the melting point of silicon and at a pressure of about 1 bar (about 100 kPa); and the pressure inside the charged and filled feeding container is reduced. Preferably, the pressure is reduced to below about 50 Torr. In this process embodiment, the steps of filling the feeding container with the ambient atmosphere and reducing the pressure may optionally be repeated.

With reference again to FIG. 13, granular polycrystalline silicon may be charged into hopper 100 through fill tube 102 in any ambient. The metering device 112 is closed to prevent granular flow through feeding nozzle 110. Granular polycrystalline silicon is typically stored in air, and the ambient during charging is typically air. After charging the hopper 100 with granular polycrystalline silicon, valve 104 to fill tube 102 is closed, while both valve 108 to gas inlet 106 and valve to feeding nozzle 110 are opened. Next, the hopper 100 is filled with soluble gas by flowing soluble gas through feeding nozzle 110 and through the granular polycrystalline silicon resting in the conical portion of hopper 100. The soluble gas may egress through gas inlet 106, until a substantial portion of insoluble gas and water are removed from the mass of granules. At that time, both valve to feeding nozzle 110 and valve 108 to gas inlet 106 may be closed, thus isolating soluble gas in the filled hopper 100, allowing the soluble gas to further saturate the granules. In an alternative of this process embodiment, soluble gas may flow through gas inlet 106, through the mass of granules, and egress through feeding nozzle 110. Again, after a substantial portion of insoluble gas and/or water are removed from the mass of granules, both valves may be closed to isolate soluble gas in thee filled hopper 100 and allow the soluble gas to further saturate the granules.

To reduce the pressure inside the charged and filled hopper 100, valve 108 may be opened and a vacuum is drawn to reduce pressure inside the hopper 100 to a pressure appropriate for feeding granular polycrystalline silicon to a growth chamber in a crystal puller apparatus. Typically, the pressure is reduced to between about 0 Torr (about 0 kPa) and about 40 Torr (about 5.3 kPa), more typically about 20 Torr (about 2.7 kPa). Optionally, hopper 100 may be filled with a gas to form the ambient atmosphere followed by pressure reduction in multiple pressure cycles to more effectively replace insoluble gas on the granules with soluble gas.

In another embodiment, a feeding container is charged with granular polycrystalline silicon; the pressure inside the charged feeding container is reduced; and the ambient atmosphere is formed inside the charged feeding container by introducing a gas having a solubility in molten silicon of at least about 5x$10^{13}$ atoms/$cm^3$ at a temperature near the melting point of silicon and at a pressure of about 1 bar (about 100 kPa) into the charged feeding container to form the ambient atmosphere, the ambient atmosphere having a mole fraction of at least 0.9 of a gas having a solubility in molten silicon of at least about 5x$10^{13}$ atoms/$cm^3$ at a temperature near the melting point of silicon and at a pressure of about 1 bar (about 100 kPa). The steps of reducing the pressure may optionally be repeated and filling the feeding container with the ambient atmosphere may be optionally repeated. In this process embodiment, the pressure inside the feeding container is generally reduced to that of the crystal puller apparatus, which is conventionally operated at a reduced pressure between about 0 Torr and about 40 Torr.

With reference to FIG. 13, granular polycrystalline silicon may be charged into hopper 100 through fill tube 102 in any ambient. The metering device 112 is closed to prevent granular flow through feeding nozzle 110. After charging the hopper 100 with granular polycrystalline silicon, any two of the three valves may be closed and a vacuum is drawn on the third, open valve to reduce the pressure inside hopper 100. Pressure reduction removes a substantial portion of insoluble gas and/or water from the mass of granules. Finally, hopper 100 may be filled with the soluble gas ambient, most conveniently through the open valve, but gas flow may be through any of the three valves. Prior to feeding the granular polycrystalline silicon to the crystal puller apparatus, the pressure is preferably reduced to a pressure appropriate for feeding granular polycrystalline silicon to a growth chamber in a crystal puller apparatus, which is typically between about 0 Torr (about 0 kPa) and about 40 Torr (about 5.3 kPa), more typically about 20 Torr (about 2.7 kPa). In some embodiments, pressure reduction is not necessary and granular feeding into the growth chamber may occur at elevated pressures, such as between about 100 Torr (about 13.3 kPa) and about 760 Torr (about 101.3 kPa), preferably between about 100 Torr (about 13.3 kPa) and about 400 Torr (about 53.3 kPa).

In yet another embodiment, the ambient atmosphere is formed in the feeding container by introducing a gas having a solubility in molten silicon of at least about 5x$10^{13}$ atoms/$cm^3$ at a temperature near the melting point of silicon and at a pressure of about 1 bar (about 100 kPa) into the charged feeding container to form the ambient atmosphere, the ambient atmosphere having a mole fraction of at least 0.9 of a gas having a solubility in molten silicon of at least about 5x$10^{13}$ atoms/$cm^3$ at a temperature near the melting point of silicon and at a pressure of about 1 bar (about 100 kPa); the filled feeding container is charged with granular polycrystalline silicon; and the pressure inside the charged and filled feeding container is reduced. Preferably, the pressure is reduced inside the feeding container to be substantially equal to the pressure inside a crystal growth chamber in a crystal puller apparatus. In this process embodiment, the steps of filling the feeding container with the ambient atmosphere and reducing the pressure may optionally be repeated.

With reference to FIG. 13, in this embodiment, any two of the three valves are opened, while one of the valves is closed. The feeding container is filled with the soluble gas ambient atmosphere by introducing soluble gas through one of the open valves, which egresses through the other open valve to effect purging of the space inside hopper 100 of air or any other gas and impurities which may be present. Thereafter, all three valves may be closed to isolate the ambient in the feeding tube. Alternatively, the gas inlet 106 may remain open, and soluble gas ambient may ingress during granular polycrystalline silicon feeding. During charging of the hopper 100 with granular polycrystalline silicon, the metering device 112 is closed and granular polycrystalline silicon is charged into hopper 100 through fill tube 102. In this embodiment, the granular silicon is likely to carry impurities into the hopper 100, since the granules are typically stored in air. Therefore, it is preferable to allow soluble gas ambient to ingress through gas inlet 106, and egress through open valve 104 of fill tube 102 to continuously purge fill tube 102 with soluble gas ambient during granular feeding. By purging the fill tube 102 with soluble gas during granular feeding, a substantial portion of water, insoluble gas, and other impurities may be removed from the granular polycrystalline silicon flow prior to the granules entering the hopper 100 cavity. After the hopper 100 is charged, valve 104 is closed, and a vacuum is drawn through gas inlet 106 to reduce pressure in hopper 100 to a pressure appropriate for feeding granular polycrystalline silicon to a growth chamber in a crystal puller apparatus, which is typically between about 0 Torr (about 0 kPa) and about 40 Torr (about 5.3 kPa), more typically about 20 Torr (about 2.7 kPa).

Variations of the process of the present invention include loading the feeding container with granular polycrystalline silicon in one batch, or in two or more batches, i.e., three, four, five, or more batches and treating each batch individually. By dividing the granules into batches, the granular surface area exposed to the ambient may be increased, thereby facilitating exchange of insoluble gases in or on the granule with soluble gas. In another embodiment, the granular polycrystalline charge may be loaded into the feeding container in an apparatus equipped in a manner which allows the silicon to flow through the ambient prior to entering the feeding container. For example, the feeding container may be equipped with an extended fill tube through which the granular polycrystalline silicon may flow. The fill tube is preferably purged with soluble gas ambient such that the granules are continuously exposed to the ambient prior to entering the feeding container. Preferably, the method of loading, either batch or flow, is sufficient to expose the granular polycrystalline silicon for a duration sufficient to achieve adequate replacement of insoluble gases on or in the granules with soluble gas and to maximize the surface area of the granules exposed to the ambient.

V. Preparing a Silicon Melt from a Charge of Treated Granular Polycrystalline Silicon

Typically, the silicon charge used to form a silicon melt comprises a combination of chunk polycrystalline silicon and granular polycrystalline silicon. Preferably, the weight of the initial loading of chunk polycrystalline silicon is about 20% to about 65% of the total melt weight and more preferably about 40% to about 60% of total melt weight. Accordingly, the amount of supplemental granular polycrystalline silicon charged to the feeding container is between about 80% and about 35% of the total melt weight, preferably between about 60% and about 40% of the total melt weight. Silicon melts typically comprise between about 40 kg and about 120 kg of silicon from the initial chunk loading and between about 210 kg and about 130 kg of silicon from supplemental granular polycrystalline silicon feeding.

In one embodiment, the silicon melt is doped with an alkaline earth metal or an alkaline earth metal containing composition. Preferably, the silicon melt is doped with an alkaline earth metal or an alkaline earth metal containing composition and the melt is formed in a quartz crucible containing a very low concentration of gases insoluble in silicon and/or having one or more tungsten doped layers. In general, alkaline earth metals, e.g., calcium, strontium, or barium, are capable of devitrifying the silica crucible surface as described more fully in U.S. Patent No. 6,461,427 and 6,350,312. While the alkaline earth metal or alkaline earth metal containing composition may be added prior to the melting of the polycrystalline silicon, it is generally preferred that it be added to molten silicon, and more preferably, added to the melt after the initial charge of polycrystalline silicon is at least partially melted. In one embodiment, the alkaline earth metal dopant is added after the melt is partially melted and the alkaline earth metal is delivered onto a mass of unmelted polycrystalline silicon residing in a pool of molten silicon. In another embodiment, the alkaline earth metal dopant is added after the entire polycrystalline silicon charge to the crucible is melted.

Regardless of when it is added, the alkaline earth metal dopant, preferably barium, strontium, or calcium, more preferably barium or strontium, is charged to the crucible, the dopant begins to cause the inside surface in contact with the melt to devitrify. Because devitrification of the crucible is not instantaneous, gases such as argon which are insoluble in silicon contained in the crucible matrix or adhering to the vitreous surface of the crucible can escape from the crucible surface and leave the melt prior to devitrification of the crucible surface and subsequent incorporation into the growing ingot as void defects. Likewise, because the devitrification is not immediate, nucleation of gases from the melt can be reduced.

Alkaline earth metal or alkaline earth metal containing compositions that may be used as dopants in accordance with the present invention include, for example, barium oxides, carbonates, silicates, acetates, silicides, hydrides, chlorides, hydroxides, and oxalates; strontium oxides, carbonates, silicates, acetates, silicides, hydrides, chlorides, hydroxides, and oxalates; and calcium oxides, carbonates, silicates, acetates, silicides, hydrides, chlorides, hydroxides, and oxalates. Alternatively, the alkaline earth metal may be in the form of an element, an ion, or as an ion pair with an organic ion. Preferred barium compounds include barium hydroxide, barium carbonate, and barium silicon oxide. Preferred strontium compounds include carbonates, oxides, hydroxides or silicates. The dopant may also be in the form of a polycrystalline silicon/alkaline earth metal alloy; barium/silicon is an example of one such alloy. At lower concentrations of barium in the barium/silicon alloy, the barium is substantially dissolved into the silicon matrix and substantially no direct chemical reaction between the barium and silicon occurs. As the amount of barium in the barium/silicon alloy increases, the dissolution limit of barium in silicon is reached and barium/silicon chemical compounds such as $BaSi_2$ and BaSi may be formed in the alloy. Similarly, at lower concentrations of strontium in the strontium/silicon alloy, the strontium is substantially dissolved into the silicon matrix and substantially no direct chemical reaction between the strontium and silicon occurs. As the amount of strontium in the strontium/silicon alloy increases, the dissolution limit of strontium in silicon is reached and strontium/silicon chemical compounds such as $SrSi_2$ and SrSi may be formed in the alloy. Thus, at higher concentrations of barium or strontium, the barium/silicon or strontium/silicon alloy may be comprised of two components; dissolved barium in silicon and barium in silicon chemical compositions or strontium in silicon and strontium/silicon chemical compounds.

Regardless of the form of the dopant, the alkaline earth metal or alkaline earth metal containing composition is utilized in an amount such that substantial incorporation of the alkaline earth metal into the body of the growing crystal does not occur and crystal properties such as oxygen induced stacking faults, point defect clusters, minority carrier lifetime and gate oxide integrity are not affected. It is preferred that no more than about 5 ppbw, preferably no more than about 3 ppbw, still more preferably no more that about 2 ppbw are incorporated into the body of the growing crystal. In addition, however, the amount of alkaline earth metal or alkaline earth metal containing composition to be added to the melt is preferably such that a thin, continuous layer of devitrified silica forms on the crucible wall in contact with the doped molten silicon.

The amount of alkaline earth metal, preferably barium or strontium, necessary to create sufficient devitrification is determined based upon the volume of the silicon charge, wetted area of the crucible surface, and type of hot zone utilized. As shown in equation (1), the amount of barium (or other alkaline earth metal) divided by the volume of the polycrystalline silicon charge divided by the wetted area of the crucible should be at least about $1.5 \times 10^{-8}$ g/cm$^3$ /cm$^2$ for conventional hot zones and at least about $6 \times 10^{-7}$ g/cm$^3$/cm$^2$ for advanced hot zones:

$$\text{barium(g)/volume of Si Charge(cm}^3\text{)/wetted area of silicon (cm}^2\text{)} \qquad (1)$$

Independent of whether an alkaline earth metal dopant is employed, the melt is typically formed in stages. Melt preparation is generally described in U.S. 2003/0101924 and U.S. 5,588,993, the disclosures of which are hereby incorporated as if set forth in their entireties. In a first stage, an initial charge of polycrystalline silicon, typically chunk polycrystalline silicon, is charged into a quartz crucible suitable for holding a silicon melt, the crucible being located in a growth chamber of a crystal puller apparatus. Heat is applied to the crucible to melt a portion of the chunk silicon while the crucible is rotated, to thereby form a partially melted charge comprising molten silicon and an island of unmelted polycrystalline silicon. The unmelted polycrystalline silicon comprises an exposed portion that is above the upper surface of the molten silicon, the exposed unmelted polycrystalline having a center and a width that corresponds to the longest distance between two points along the interface between the exposed unmelted polycrystalline silicon and the upper surface of the molten silicon. The interface between the unmelted polycrystalline silicon and the upper surface of the molten silicon is also approximately equidistant from the center of the unmelted polycrystalline silicon.

In a second stage, a supplemental charge of granular polycrystalline silicon held in a feeding container is fed into the shallow melt. According to the method of the present invention, the supplemental charge of granular polycrystalline silicon is held in a feeding container comprising the ambient atmosphere having a mole fraction of at least 0.9 of a gas having a solubility in molten silicon of at least about $5 \times 10^{13}$ atoms/cm at a temperature near the melting point of silicon and at a pressure of about 1 bar (about 100 kPa), formed in the feeding container according to the method described herein. The granular polycrystalline silicon is fed into the rotating crucible from the feeding container onto the exposed unmelted polycrystalline silicon thereby maintaining the width of the exposed unmelted polycrystalline silicon. The feeding method may be continuous or intermittent, and in general, the feeding rate is controlled to maintain the width of exposed unmelted silicon relatively constant. At typical feeding rates from about 10 kg/hour to about 30 kg/hour, e.g., 20 kg/hour, the total time to complete granular feeding, although typically about 6 to 14 hours, may be, in some embodiments, as high as 20 hours.

Since the growth chamber of the crystal puller apparatus is conventionally purged with argon gas, argon purge gas may contaminate the feeding container during the relatively long feeding process, particularly when the feeding nozzle is open during granular feeding. It is therefore preferable to take steps to reform the ambient atmosphere in the feeding container. In one embodiment, the ambient atmosphere in the feeding container is reformed during granular feeding by introducing a stream of a gas having a solubility in molten silicon of at least about 5x10 atoms/cm$^3$ at a

temperature near the melting point of silicon and at a pressure of about 1 bar (about 100 kPa) into the feeding container while the granular polycrystalline silicon is held therein. Preferably, the gas has a solubility in molten silicon of at least about $1x10^{14}$ atoms/$cm^3$, more preferably at least about $1x10^{15}$ atoms/$cm^3$, still more preferably at least about 1 $x10^{16}$ atoms/$cm^3$, still more preferably at least about $1x10^{17}$ atoms/$cm^3$, and even more preferably at least about $6x10^{18}$ atoms/$cm^3$. As stated above, such gases include nitrogen, hydrogen, chlorine, hydrogen chloride, and ammonia, and combinations of these gases may be used. Preferably, the gas introduced into the feeding container during granular feeding is identical to the gas used to form the initial ambient atmosphere in the feeding container. In this regard, a stream of nitrogen is particularly preferred. Periodically introducing a soluble gas stream into the feeding container during granular polycrystalline silicon feeding inhibits recontamination of the granules with insoluble gases, such as argon, during granular feeding. It has been discovered that periodically introducing soluble gas into the feeding container is effective at further reducing the occurrence of air pockets in the growing single crystal silicon ingot.

To further minimize re-contaminating the granules with argon purge gas, the melt preparation process is preferably controlled to minimize the duration of exposure of the granules to the argon purge gas after the granules have been fed into the crucible in the crystal growth chamber. Conventionally, granular polycrystalline silicon is fed onto an island of unmelted silicon during the melt preparation. During granular polycrystalline silicon feeding, the residence time of the granules on the island is preferably controlled to achieve adequate evaporation of hydrogen from the granular polycrystalline silicon and allow for slow temperature equilibration prior to melting, while also preventing an excessive residence time on the island which may result in argon contamination of the granules. In view of these considerations, the granular polycrystalline residence time on the islands of unmelted silicon is preferably less than about 30 minutes, more preferably less than about 20 minutes, while the residence time is preferably at least a few seconds to achieve dehydrogenation. Accordingly, the residence time is preferably between about 4 seconds and about 6 minutes, more preferably between about 10 seconds and about 3 minutes.

The residence time is a function of several process parameters associated with granular polycrystalline feeding onto an island of unmelted silicon, including the island diameter, island depth, and granular flow rate. Preferably, these parameters are optimized to yield an island of unmelted silicon having a diameter sufficiently large to leave a gap between the island periphery and the surface of the interior wall of the crucible of between about 0.5 cm and about 5.0 cm, more preferably the gap is between about 1.0 cm and about 4.0 cm, such as about 2.5 cm gap. Moreover, the depth of the island of unmelted silicon is preferably between about 0.5 cm and about 5 cm, more preferably between about 1 cm and about 4 cm. Optimizing these process parameters to yield granular residence times on the island of unmelted silicon is a function of the mass of the total silicon melt, crucible size, crucible rotation rate, and other factors, and may be determined empirically.

Once the entire mass of granular polycrystalline silicon is added, the silicon is heated until the entire silicon mass is melted. A single crystal silicon ingot may then be pulled from the melt by a conventional Czochralski process.

Having described the invention in detail, it will be apparent that modifications and variations are possible without departing from the scope of the invention defined in the appended claims.

## EXAMPLES

The following non-limiting examples are provided to further illustrate the present invention.

Example

Four groups of single crystal silicon ingots were grown from silicon melts, each crystal having a 300 mm diameter and grown to a length of 112 cm. The mass of each silicon charge was approximately 250 kg, comprising about 100 kg chunk polycrystalline silicon and about 150 kg granular polycrystalline silicon. Each silicon charge was melted in a 28 inch crucible in a Ferrofluidics furnace. The interior wall of each crucible was devitrified by adding about 2.0 grams barium carbonate to the silicon melt during meltdown. The silicon ingots were grown according to the conventional Czochralski method and sliced into wafers. The wafers were polished and inspected for voids using an IR camera. The IR camera uses infrared radiation instead of visible radiation to allow inspection of the interior of wafers.

To prepare the silicon melt used to grow each of the first group of single crystal ingots, the granular polycrystalline silicon charge was fed into a feeding container and subjected to a conventional pumpdown and backfill sequence in which the feeding container was backfilled with argon gas to the feeding pressure, which was about 20 Torr. When the chunk polycrystalline silicon charge was placed into the crucible, the 2.0 grams of barium carbonate was placed near the top of the chunk polycrystalline silicon stack. Thereafter, the chunk polycrystalline silicon was brought to a pressure of 20 Torr and a temperature of 1500°C and partially melted. Granular polycrystalline silicon was fed onto an island of unmelted silicon in the melt at a flow rate of about 20 kg/hour, sufficient to yield an island having an approximately 2.5 cm gap between the island periphery and the interior wall of the crucible. The residence time of the granular silicon on the island before melting is approximately 20 minutes. The melting process took about 11 hours before the entire charge of silicon melted. Thereafter, a 300 mm diameter single crystal ingot was grown to a length of 112 cm. The ingot was sliced and ground into 300 mm diameter wafers. The wafers were polished and inspected for voids using an IR camera. The % wafer loss of this population of wafers for various defect sizes corresponds to 1 on the abscissa of the bar chart depicted in FIG. 14. Approximately 20,000 wafers were analyzed from approximately 50 ingots. Within this population of waters, about 25% of the wafers were found to have defects greater than 50 micrometers; about 11 % of the wafers were found to have defects greater than 100 micrometers; and about 3.5% of the wafers were found to have defects greater than 200 micrometers.

To prepare the silicon melt used to grow each of the second group of single crystal ingots, the granular polycrystalline silicon charge was fed into a feeding container and subjected to a conventional pumpdown and backfill sequence in which the feeding container was backfilled with argon gas to the feeding pressure, which was about 20 Torr. Thereafter, the chunk polycrystalline silicon was brought to a pressure of 10 Torr and a temperature of 1500°C and partially melted. Granular polycrystalline silicon was fed onto an island of unmelted silicon in the melt at a flow rate of about 20 kg/hour, sufficient to yield an island having an approximately 2.5 cm gap between the island periphery and the interior wall of the crucible. The residence time of the granular silicon on the island before melting is approximately 20 minutes. Before the final 10 kg of granular polycrystalline silicon was fed, 2.0 grams of barium carbonate were fed onto the granular silicon island, and then the final 10 kg of granular polycrystalline silicon were fed, on top of the barium carbonate. The melting process took about 11 hours before the entire charge of silicon melted. Thereafter, a 300 mm diameter single crystal ingot was grown to a length of 112 cm. The ingot was sliced and ground into 300 mm diameter wafers. The wafers were polished and inspected for voids using an IR camera. The % wafer loss of this population of wafers for various defect sizes corresponds to 2 on the abscissa of the bar chart depicted in FIG. 14. Approximately 19,000 wafers were analyzed from approximately 48 ingots. Within this population of waters, about 6.4% of the wafers were found to have defects greater than 50 micrometers; about 3.2% of the wafers were found to have defects greater than 100 micrometers; and about 0.9% of the wafers were found to have defects greater than 200 micrometers.

To prepare the silicon melt used to grow each of the third group of single crystal ingots, the granular polycrystalline silicon charge was fed into a feeding container and subjected to a pumpdown and backfill sequence in which the feeding container was backfilled with nitrogen gas to the feeding pressure, which was about 20 Torr. Thereafter, the polycrystalline silicon was brought to a pressure of 10 Torr and a temperature of 1500°C and partially melted. Granular polycrystalline silicon was fed onto an island of unmelted silicon in the melt at a flow rate of about 20 kg/hours, sufficient to yield an island having an approximately 2.5 cm gap between the island periphery and the interior wall of the crucible. In this case, the ambient atmosphere in the feeding container was not reformed during granular feeding. The residence time of the granular silicon on the island before melting is approximately 20 minutes. Before the final 10 kg of granular polycrystalline silicon was fed, 2.0 grams of barium carbonate were fed onto the granular silicon island, and then the final 10 kg of granular polycrystalline silicon were fed, on top of the barium carbonate. The melting process took about 11 hours before the entire charge of silicon melted. Thereafter, a 300 mm diameter single crystal ingot was grown to a length of 112 cm. The ingot was sliced and ground into 300 mm diameter wafers. The wafers were polished and inspected for voids using an IR, camera. The % wafer loss of this population of wafers for various defect sizes corresponds to 3 on the abscissa of the bar chart depicted in FIG. 14. Approximately 10,200 wafers were analyzed from approximately 26 ingots. Within this population of waters, about 4.4% of the wafers were found to have defects greater than 50 micrometers; about 2.2% of the wafers were found to have defects greater than 100 micrometers; and about 0.84% of the wafers were found to have defects greater than 200 micrometers.

To prepare the silicon melt used to grow each of the fourth group of single crystal ingots, the granular polycrystalline silicon charge was fed into a feeding container and subjected to a pumpdown and backfill sequence in which the feeding container was backfilled with nitrogen gas to the feeding pressure, which was about 20 Torr. Thereafter, the polycrystalline silicon was brought to a pressure of 10 Torr and a temperature of 1500°C and partially melted. Granular polycrystalline silicon was fed onto an island of unmelted silicon in the melt at a flow rate of about 20 kg/hour, sufficient to yield an island having an approximately 2.5 cm gap between the island periphery and the interior wall of the crucible. In this case, the ambient atmosphere was reformed in the feeding container during granular feeding by flowing nitrogen gas into the feeding container. The residence time of the granular silicon on the island before melting is approximately 20 minutes. Before the final 10 kg of granular polycrystalline silicon was fed, 2.0 grams of barium carbonate were fed onto the granular silicon island, and then the final 10 kg of granular polycrystalline silicon were fed, on top of the barium carbonate. The melting process took about 11 hours before the entire charge of silicon melted. Thereafter, a 300 mm diameter single crystal ingot was grown to a length of 112 cm. The ingot was sliced and ground into 300 mm diameter wafers. The wafers were polished and inspected for voids using an IR camera. The % wafer loss of this population of wafers for various defect sizes corresponds to 4 on the abscissa of the bar chart depicted in FIG. 14. Approximately 3700 wafers were analyzed from approximately 10 ingots. Within this population of waters, about 0.94% of the wafers were found to have defects greater than 50 micrometers; about 0.37% of the wafers were found to have defects greater than 100 micrometers; and about 0.12% of the wafers were found to have defects greater than 200 micrometers.

The results of IR inspection are shown in FIG. 14. To construct the bar chart depicted in FIG. 14, the wafers sliced from each ingot were scanned using an IR camera for defects having a size greater than 50 micrometers (left bar), defects having a size greater than 100 micrometers (center bar), and defects having a size greater than 200 micrometers (right bar). While reducing the pressure inside the crystal growth chamber during the partial melting of the chunk polycrystalline silicon, along with the late-stage addition of the barium carbonate, substantially reduces the number of defects in the wafer population compared to the process in which the pressure inside the crystal growth chamber is not reduced and the barium carbonate is added along with the chunk polycrystalline silicon, it is apparent that backfilling the feeding container with nitrogen achieves an even further reduction in wafer defects. The reduction of wafer defects is further improved where the ambient atmosphere is reformed in the feeding container by flowing nitrogen gas into the feeding container during granular feeding.

When introducing elements of the present invention or the preferred embodiments(s) thereof, the articles "a", "an", "the" and "said" are intended to mean that there are one or more of the elements. The terms "comprising", "including" and "having" are intended to be inclusive and mean that there may be additional elements other than the listed elements.

In view of the above, it will be seen that the several objects of the invention are achieved and other advantageous results attained.

As various changes could be made in the above methods without departing from the scope of the invention, it is intended that all matter contained in the above description and shown in the accompanying drawings shall be interpreted as illustrative and not in a limiting sense.

## Claims

**1.** A process for controlling the amount of insoluble gas carried by a charge of granular polycrystalline silicon, the process comprising:

(i) charging a feeding container with granular polycrystalline silicon,
(ii) forming an ambient atmosphere in the feeding container, the ambient atmosphere having a mole fraction of at least 0.9 of a gas having a solubility in molten silicon of at least about $5 \times 10^{13}$ atoms/$cm^3$ at a temperature near the melting point of silicon and at a pressure of about 1 bar (about 100 kPa), and
(iii) reducing the pressure inside the charged feeding container.

**2.** The process of claim 1 wherein step (ii) is carried out before step (iii).

**3.** The process of claim 1 wherein step (iii) is carried out before step (ii).

**4.** The process of claim 1 wherein step (ii) is carried out before step (i).

**5.** The process of claim 1 wherein at least one of steps (ii) and (iii) is carried out at least twice.

**6.** The process of claim 1 wherein the gas has a solubility in molten silicon of at least about $1 \times 10^{14}$ atoms/$cm^3$, preferably at least about $1 \times 10^{15}$ atoms/$cm^3$, more preferably at least about $1 \times 10^{16}$ atoms/$cm^3$, still more preferably at least about $1 \times 10^{17}$ atoms/$cm^3$, and even more preferably at least about $6 \times 10^{18}$ atoms/$cm^3$ at a temperature near the melting point of silicon and at a pressure of about 1 bar (about 100 kPa).

**7.** The process of claim 1 wherein the ambient atmosphere comprises a mole fraction of at least 0.9 of a gas selected from the group consisting of nitrogen, hydrogen, chlorine, hydrogen chloride, ammonia, and combinations thereof, preferably a mole fraction of at least 0.9 of nitrogen.

**8.** The process of claim 1 wherein the mole fraction is at least 0.95 of the gas, preferably the mole fraction is at least about 0.97 of the gas having a solubility in molten silicon of at least about $5 \times 10^{13}$ atoms/$cm^3$ at a temperature near the melting point of silicon and at a pressure of about 1 bar (about 100 kPa).

**9.** The process of claim 1 wherein the pressure inside the charged feeding container is reduced to between about 0 Torr (0 kPa) and about 40 Torr (about 5.3 kPa).

**10.** The process of claim 9 wherein the pressure is reduced for a duration between about 15 seconds and about 60 minutes.

**11.** The process of claim 1 wherein the ambient atmosphere is formed in the feeding container at an ambient pressure between about 10 Torr (about 1.3 kPa) and about 1 atm (about 101.3 kPa), preferably at an ambient pressure about 10 Torr (about 1.3 kPa) and about 100 Torr (about 13.3 kPa).

**12.** The process of claim 11 further comprising holding the ambient atmosphere in the feeding container at said ambient pressure for a duration between about 15 seconds and about 60 minutes.

**13.** A process for preparing a silicon melt in a crucible in a growth chamber of a crystal puller apparatus, the process comprising:

feeding an initial charge of polycrystalline silicon to the crucible residing in the growth chamber of the crystal puller apparatus and melting a fraction of the initial charge to thereby form a partially melted charge;
holding granular polycrystalline silicon in a feeding container having an ambient atmosphere as the initial charge is being melted, the ambient atmosphere having a mole fraction of at least 0.9 of a gas having a solubility in molten silicon of at least about $5x10^{13}$ atoms/$cm^3$ at a temperature near the melting point of silicon and at a pressure of about 1 bar (about 100 kPa); and
feeding the held granular polycrystalline silicon to the crucible to supplement the initial charge, and melting the supplemental charge of granular polycrystalline silicon to form the silicon melt in the crucible.

**14.** The process of claim 13 further comprising introducing a stream of a gas having a solubility in molten silicon of at least about $5x10^{13}$ atoms/$cm^3$ at a temperature near the melting point of silicon and at a pressure of about 1 bar (about 100 kPa) into the feeding container while the granular polycrystalline silicon is held therein.

**15.** The process of claims 13 or 14 further comprising adding an alkaline earth metal containing composition to the partially melted charge prior to feeding the supplemental charge of granular polycrystalline silicon.

**Patentansprüche**

**1.** Ein Verfahren zur Kontrolle der Menge von unlöslichem Gas, das in einer Ladung von granularem polykristallinem Silizium mitgeführt wird, wobei das Verfahren

(i) das Beladen eines Zufuhrbehälters mit granularem polykristallinem Silizium,
(ii) die Bildung einer Umgebungsatmosphäre im Zufuhrbehälter, wobei die Umgebungsatmosphäre einen molaren Anteil von mindestens 0,9 eines Gases hat, das eine Löslichkeit in geschmolzenem Silizium von mindestens etwa $5 \times 10^{13}$ Atomen/$cm^3$ bei einer Temperatur nahe dem Schmelzpunkt von Silizium und bei einem Druck von etwa 1 bar (etwa 100 kPa) hat, und
(iii) die Reduktion des Drucks innerhalb des beladenen Zufuhrbehälters umfasst.

**2.** Das Verfahren gemäß Anspruch 1, wobei Schritt (ii) vor Schritt (iii) ausgeführt wird.

**3.** Das Verfahren gemäß Anspruch 1, wobei Schritt (iii) vor Schritt (ii) ausgeführt wird.

**4.** Das Verfahren gemäß Anspruch 1, wobei Schritt (ii) vor Schritt (i) ausgeführt wird.

**5.** Das Verfahren gemäß Anspruch 1, wobei mindestens einer der Schritte (ii) und (iii) mindestens zweimal ausgeführt wird.

**6.** Das Verfahren gemäß Anspruch 1, wobei das Gas eine Löslichkeit in geschmolzenem Silizium von mindestens etwa $1 \times 10^{14}$ Atomen/$cm^3$, bevorzugt von mindestens etwa $1 \times 10^{15}$ Atomen/$cm^3$, mehr bevorzugt von mindestens etwa $1 \times 10^{16}$ Atomen/$cm^3$, noch mehr bevorzugt von mindestens etwa $1 \times 10^{17}$ Atomen/$cm^3$ und sogar noch mehr bevorzugt von mindestens etwa $6 \times 10^{18}$ Atomen/$cm^3$ bei einer Temperatur nahe dem Schmelzpunkt von Silizium und bei einem Druck von etwa 1 bar (etwa 100 kPa) hat.

**7.** Das Verfahren gemäß Anspruch 1, wobei die Umgebungsatmosphäre einen molaren Anteil von mindestens 0,9 eines Gases umfasst, das aus der Gruppe ausgewählt ist, die aus Stickstoff, Wasserstoff, Chlor, Chlorwasserstoff, Ammoniak und Kombinationen daraus besteht, bevorzugt einen molaren Anteil von mindestens 0,9 an Stickstoff.

**8.** Das Verfahren gemäß Anspruch 1, wobei der molare Anteil mindestens 0,95 des Gases ist, bevorzugt ist der molare Anteil mindestens etwa 0,97 des Gases, das eine Löslichkeit in geschmolzenen Silizium von mindestens etwa 5 x $10^{13}$ Atomen/$cm^3$ bei einer Temperatur nahe dem Schmelzpunkt von Silizium und bei einem Druck von etwa 1 bar (etwa 100 kPa) hat.

**9.** Das Verfahren gemäß Anspruch 1, wobei der Druck innerhalb des beladenen Zufuhrbehälters auf einen Bereich zwischen etwa 0 Torr (0 kPa) und etwa 40 Torr (etwa 5,3 kPa) reduziert ist.

**10.** Das Verfahren gemäß Anspruch 9, wobei der Druck für eine Dauer zwischen etwa 15 Sekunden und etwa 60 Minuten reduziert ist.

**11.** Das Verfahren gemäß Anspruch 1, wobei die Umgebungsatmosphäre in dem Zufuhrbehälter bei einem Umgebungsdruck zwischen etwa 10 Torr (etwa 1,3 kPa) und etwa 1 Atm (etwa 101,3 kPa) gebildet wird, bevorzugt bei einem Umgebungsdruck zwischen etwa 10 Torr (etwa 1,3 kPa) und etwa 100 Torr (etwa 13,3 kPa).

**12.** Das Verfahren gemäß Anspruch 11, das zusätzlich das Aufrechterhalten der Umgebungsatmosphäre im Zufuhrbehälter bei dem genanntem Umgebungsdruck für eine Dauer zwischen etwa 15 Sekunden und etwa 60 Minuten umfasst.

**13.** Ein Verfahren zur Herstellung einer Siliziumschmelze in einem Schmelztiegel in einer Wachstumskammer eines Kristallziehungsapparates, das Verfahren umfassend
die Zufuhr einer Anfangsladung von polykristallinem Silizium in den Schmelztiegel, der sich in der Wachstumskammer des Kristallziehungsapparates befindet, und das Schmelzen eines Teils der Anfangsladung, um dadurch eine teilweise geschmolzenen Ladung zu bilden; das Zurückhalten von granularem polykristallinem Silizium in einem Zufuhrbehälter, der eine Umgebungsatmosphäre hat, während die Anfangsladung geschmolzen wird, wobei die Umgebungsatmosphäre einen molaren Anteil von mindestens 0,9 eines Gases hat, das eine Löslichkeit in geschmolzenem Silizium von mindestens etwa 5 x $10^{13}$ Atomen/$cm^3$ bei einer Temperatur nahe dem Schmelzpunkt von Silizium und bei einem Druck von etwa 1 bar (etwa 100 kPa) hat; und die Zufuhr des zurückgehaltenen granularen polykristallinen Siliziums in den Schmelztiegel, um die Anfangsladung zu ergänzen, und das Schmelzen der Zusatzladung von granularem polykristallinem Silizium, um die Siliziumschmelze im Schmelztiegel zu bilden.

**14.** Das Verfahren gemäß Anspruch 13, das zusätzlich das Einleiten eines Gasstroms von Gas, das eine Löslichkeit in geschmolzenem Silizium von mindestens etwa 5 x $10^{13}$ Atomen/$cm^3$ bei einer Temperatur nahe dem Schmelzpunkt von Silizium und bei einem Druck von etwa 1 bar (etwa 100 kPa) hat, in den Zufuhrbehälter umfasst, während das granulare polykristalline Silizium darin zurückgehalten wird.

**15.** Das Verfahren gemäß Anspruch 13 oder 14, das zusätzlich die Zugabe einer Alkali-Erdmetall-enthaltenden Zusammensetzung zu der teilweise geschmolzenen Ladung vor der Zugabe der Zusatzladung von granularem polykristallinem Silizium umfasst.

## Revendications

**1.** Procédé de contrôle de la quantité de gaz insoluble porté par une charge de silicium polycristallin granulaire, le procédé comprenant :

(i) le chargement d'un récipient d'alimentation avec du silicium polycristallin granulaire,
(ii) la formation d'une atmosphère ambiante dans le récipient d'alimentation, l'atmosphère ambiante ayant une fraction molaire d'au moins 0,9 d'un gaz ayant une solubilité dans le silicium fondu d'au moins environ 5 x $10^{13}$ atomes/$cm^3$ à une température proche du point de fusion du silicium et à une pression d'environ 1 bar (environ 100 kPa), et
(iii) la réduction de la pression à l'intérieur du récipient d'alimentation chargé.

**2.** Procédé selon la revendication 1, dans lequel l'étape (ii) est réalisée avant l'étape (iii).

**3.** Procédé selon la revendication 1, dans lequel l'étape (iii) est réalisée avant l'étape (ii).

**4.** Procédé selon la revendication 1, dans lequel l'étape (ii) est réalisée avant l'étape (i).

**5.** Procédé selon la revendication 1, dans lequel au moins une des étapes (ii) et (iii) est réalisée au moins deux fois.

**6.** Procédé selon la revendication 1, dans lequel le gaz a une solubilité dans le silicium fondu d'au moins environ 1 x $10^{14}$ atomes/$cm^3$, de préférence d'au moins environ 1 x $10^{15}$ atomes/$cm^3$, plus préférablement d'au moins environ 1 x $10^{16}$ atomes/$cm^3$, toujours plus préférablement d'au moins environ 1 x $10^{17}$ atomes/$cm^3$ et encore plus préférablement d'au moins environ 6 x $10^{18}$ atomes/$cm^3$ à une température proche du point de fusion du silicium et à une pression d'environ 1 bar (environ 100 kPa).

**7.** Procédé selon la revendication 1, dans lequel l'atmosphère ambiante comprend une fraction molaire d'au moins 0,9 d'un gaz sélectionné dans le groupe constitué par l'azote, l'hydrogène, le chlore, le chlorure d'hydrogène, l'ammoniac et des combinaisons de ceux-ci, de préférence une fraction molaire d'au moins 0,9 d'azote.

**8.** Procédé selon la revendication 1, dans lequel la fraction molaire est d'au moins 0,95 du gaz, de préférence la fraction molaire est d'au moins environ 0,97 du gaz ayant une solubilité dans le silicium fondu d'au moins environ 5 x $10^{13}$ atomes/$cm^3$ à une température proche du point de fusion du silicium et à une pression d'environ 1 bar (environ 100 kPa).

**9.** Procédé selon la revendication 1, dans lequel la pression à l'intérieur du récipient d'alimentation chargé est réduite de manière à se situer entre environ 0 torr (0 kPa) et environ 40 torr (environ 5,3 kPa).

**10.** Procédé selon la revendication 9, dans lequel la pression est réduite pour une durée entre environ 15 secondes et environ 60 minutes.

**11.** Procédé selon la revendication 1, dans lequel l'atmosphère ambiante est formée dans le récipient d'alimentation à une pression ambiante entre environ 10 torr (environ 1,3 kPa) et environ 1 atm (environ 101,3 kPa), de préférence à une pression ambiante d'environ 10 torr (environ 1,3 kPa) et d'environ 100 torr (environ 13,3 kPa).

**12.** Procédé selon la revendication 11 comprenant en outre le maintien de l'atmosphère ambiante dans le récipient d'alimentation à ladite pression ambiante pour une durée entre environ 15 secondes et environ 60 minutes.

**13.** Procédé de préparation de silicium fondu dans un creuset dans une chambre de croissance d'un appareil de tirage de cristaux, le procédé comprenant :

l'introduction d'une charge initiale de silicium polycristallin dans le creuset situé dans la chambre de croissance de l'appareil de tirage de cristaux et la fusion d'une fraction de la charge initiale pour ainsi former une charge partiellement fondue ;
le maintien du silicium polycristallin granulaire dans un récipient d'alimentation ayant une atmosphère ambiante au fur et à mesure que la charge initiale fond, l'atmosphère ambiante ayant une fraction molaire d'au moins 0,9 d'un gaz ayant une solubilité dans le silicium fondu d'au moins environ 5 x $10^{13}$ atomes/$cm^3$ à une température proche du point de fusion du silicium et à une pression d'environ 1 bar (environ 100 kPa) ; et
l'introduction dans le creuset du silicium polycristallin maintenu granulaire pour compléter la charge initiale, et la fusion de la charge supplémentaire de silicium polycristallin granulaire pour former le silicium fondu dans le creuset.

**14.** Procédé selon la revendication 13 comprenant en outre l'introduction d'un flux d'un gaz ayant une solubilité dans le silicium fondu d'au moins environ 5 x $10^{13}$ atomes/$cm^3$ à une température proche du point de fusion du silicium et à une pression d'environ 1 bar (environ 100 kPa) dans le récipient d'alimentation tandis que le silicium polycristallin granulaire est maintenu à l'intérieur.

**15.** Procédé selon les revendications 13 ou 14 comprenant en outre l'ajout d'une composition contenant un métal alcalinoterreux à la charge partiellement fondue avant d'introduire la charge supplémentaire de silicium polycristallin granulaire.

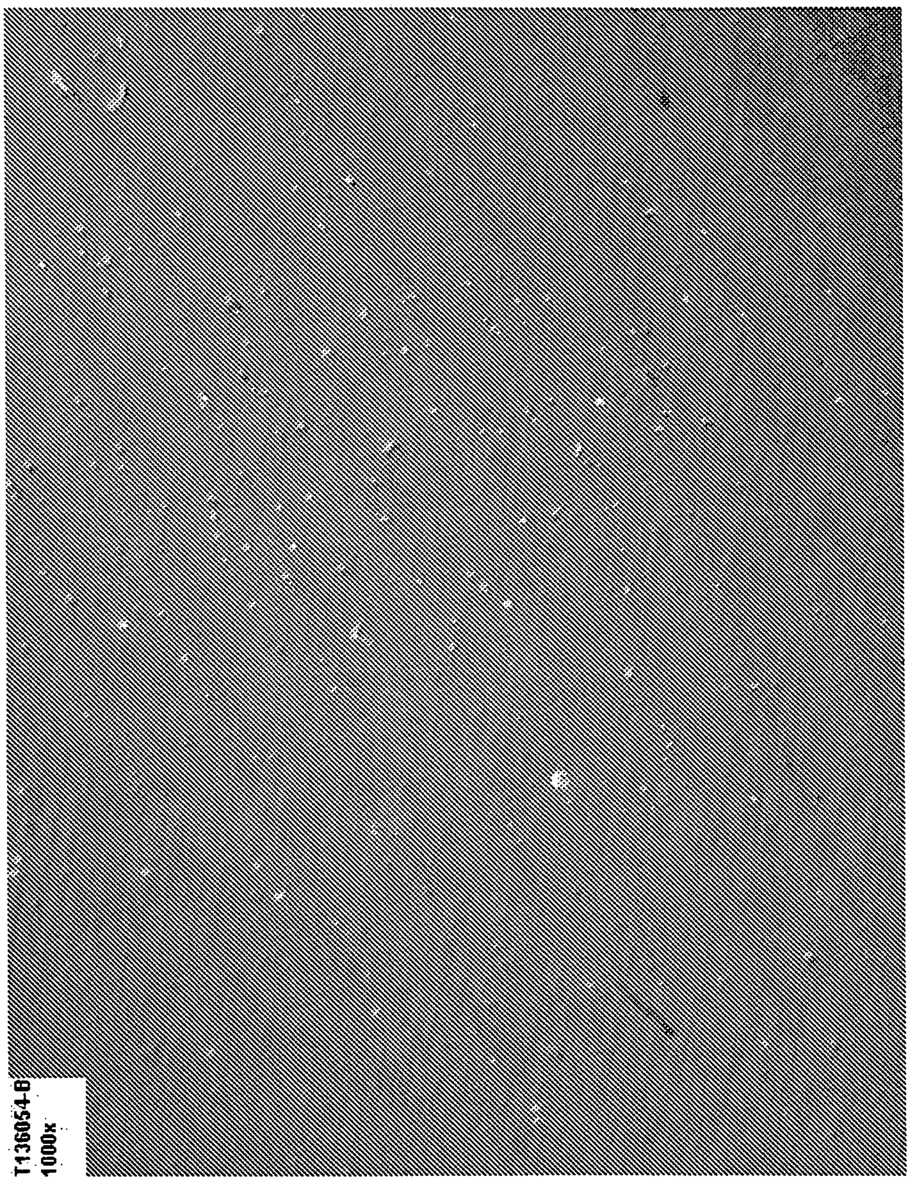


FIG. 1

FIG. 2

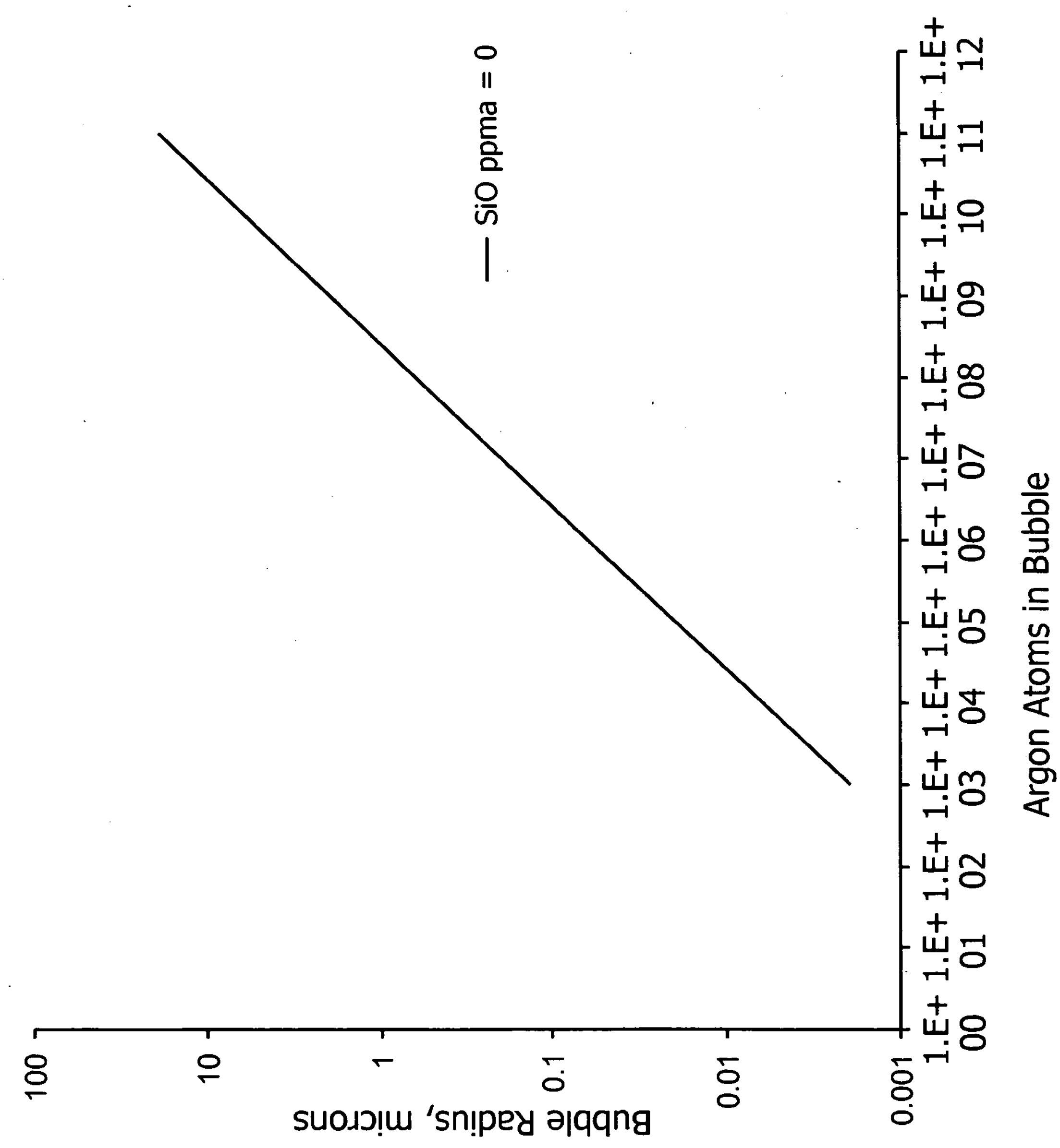
SiO ppma = 0
Bubble Radius, microns
100
10
1
0.1
0.01
0.001
Argon Atoms in Bubble
1.E+00
1.E+01
1.E+02
1.E+03
1.E+04
1.E+05
1.E+06
1.E+07
1.E+08
1.E+09
1.E+10
1.E+11
1.E+12

FIG. 3

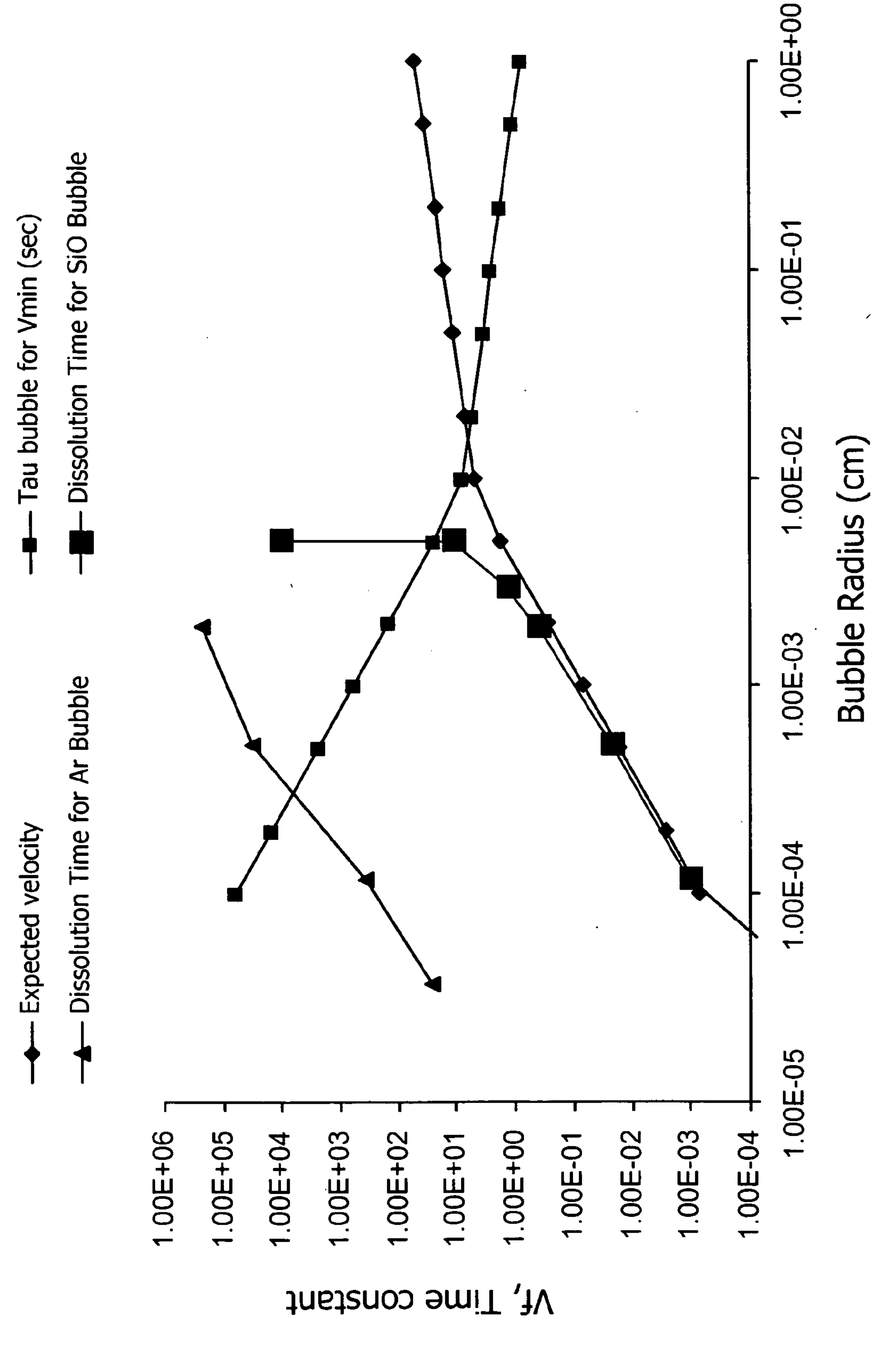

Expected velocity
Dissolution Time for Ar Bubble
Tau bubble for Vmin (sec)
Dissolution Time for SiO Bubble
Vf, Time constant
1.00E+06
1.00E+05
1.00E+04
1.00E+03
1.00E+02
1.00E+01
1.00E+00
1.00E-01
1.00E-02
1.00E-03
1.00E-04
1.00E-05
1.00E-04
1.00E-03
1.00E-02
1.00E-01
1.00E+00
Bubble Radius (cm)

FIG. 4

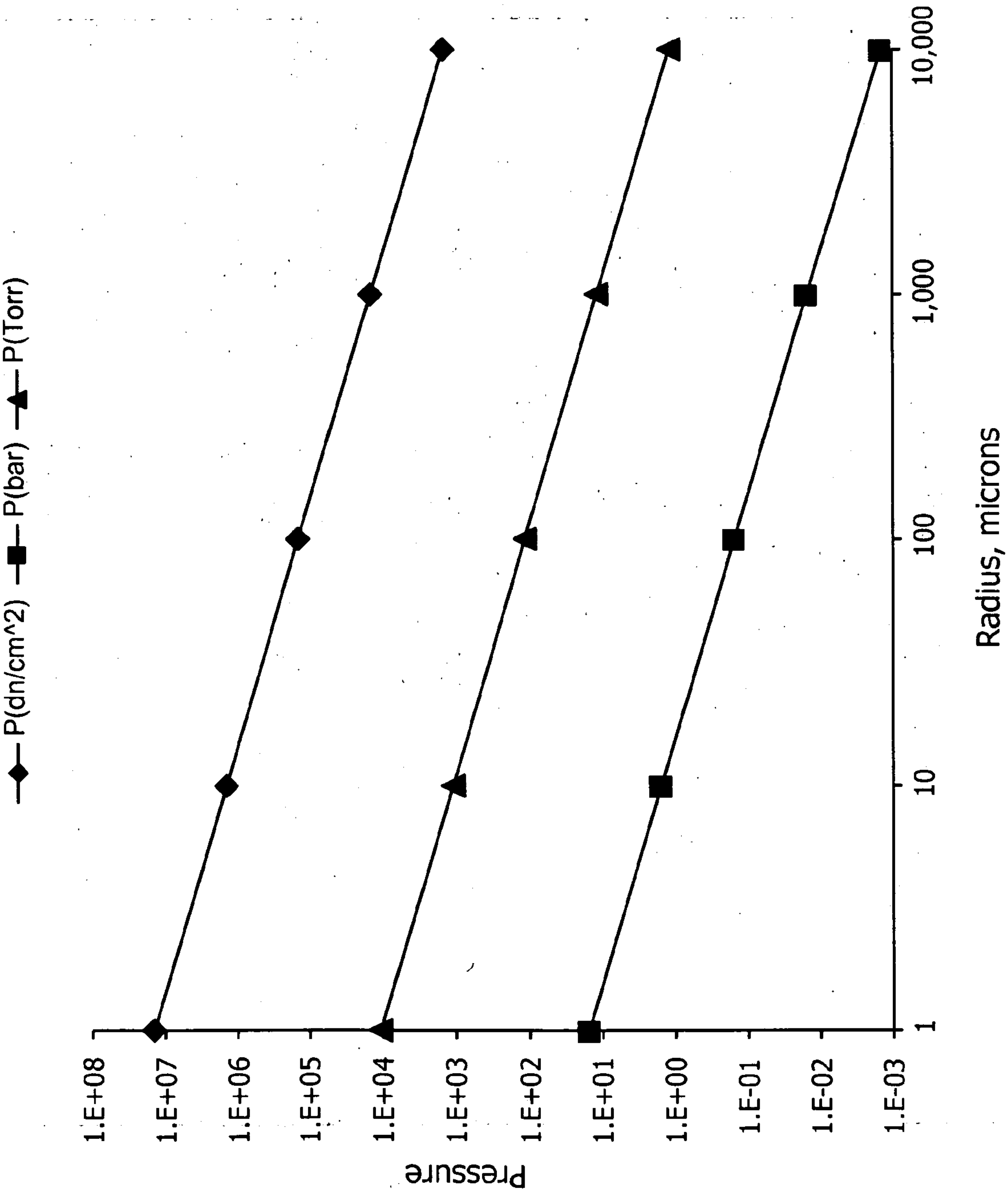
P(dn/cm^2)
P(bar)
P(Torr)
Pressure
1.E+08
1.E+07
1.E+06
1.E+05
1.E+04
1.E+03
1.E+02
1.E+01
1.E+00
1.E-01
1.E-02
1.E-03
1
10
100
1,000
10,000
Radius, microns

FIG. 5

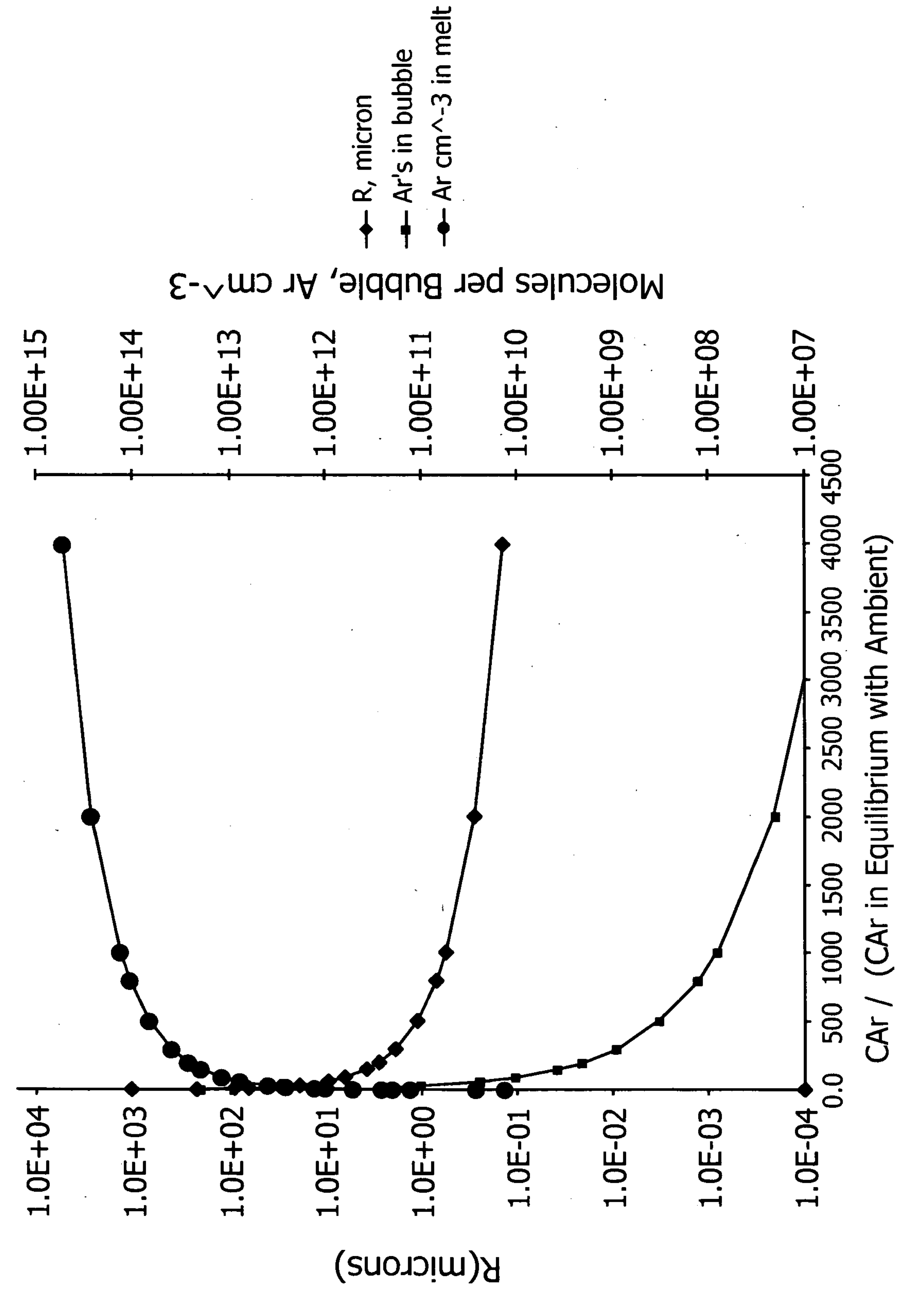
R(microns)
1.0E+04
1.0E+03
1.0E+02
1.0E+01
1.0E+00
1.0E-01
1.0E-02
1.0E-03
1.0E-04
0.0
500
1000
1500
2000
2500
3000
3500
4000
4500
CAr / (CAr in Equilibrium with Ambient)
1.00E+15
1.00E+14
1.00E+13
1.00E+12
1.00E+11
1.00E+10
1.00E+09
1.00E+08
1.00E+07
Molecules per Bubble, Ar cm^-3
R, micron
Ar's in bubble
Ar cm^-3 in melt

FIG. 6

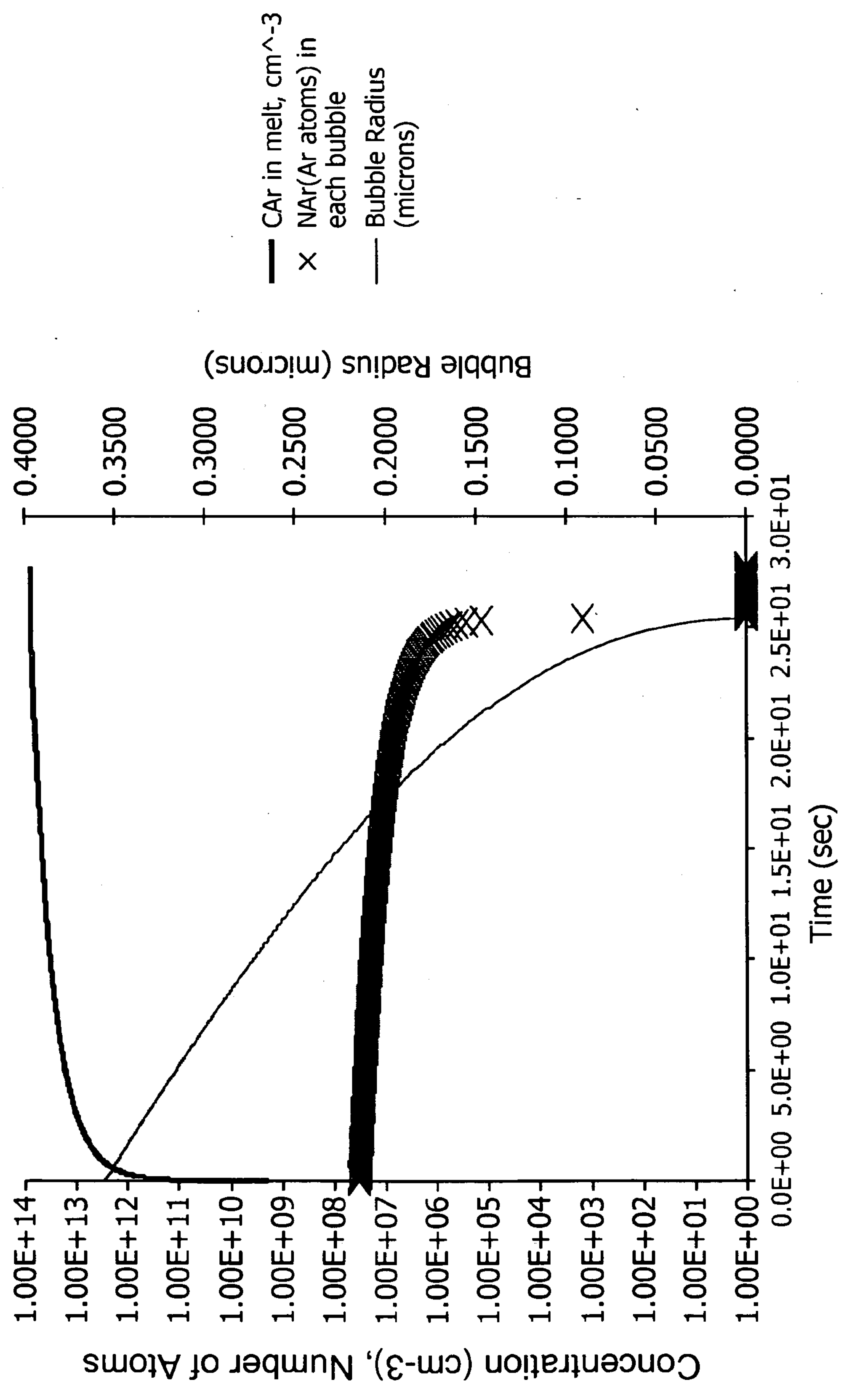

Concentration (cm-3), Number of Atoms
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
0.0E+00
5.0E+00
1.0E+01
1.5E+01
2.0E+01
2.5E+01
3.0E+01
Time (sec)
0.4000
0.3500
0.3000
0.2500
0.2000
0.1500
0.1000
0.0500
0.0000
Bubble Radius (microns)
CAr in melt, cm^-3
NAr(Ar atoms) in each bubble
Bubble Radius (microns)

FIG. 7

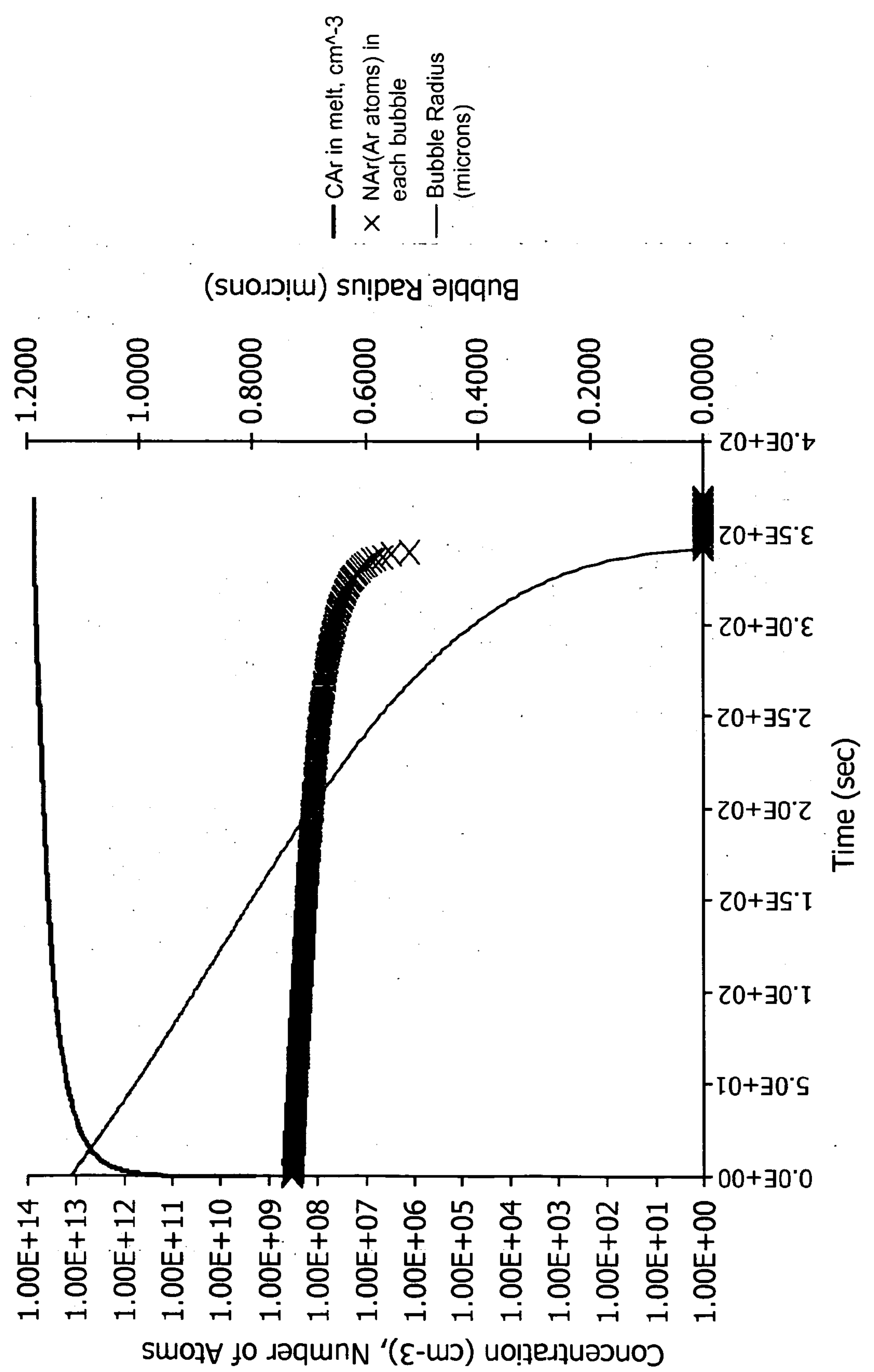

Concentration (cm-3), Number of Atoms
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
Time (sec)
0.0E+00
5.0E+01
1.0E+02
1.5E+02
2.0E+02
2.5E+02
3.0E+02
3.5E+02
4.0E+02
Bubble Radius (microns)
1.2000
1.0000
0.8000
0.6000
0.4000
0.2000
0.0000
CAr in melt, cm^-3
NAr(Ar atoms) in each bubble
Bubble Radius (microns)

FIG. 8

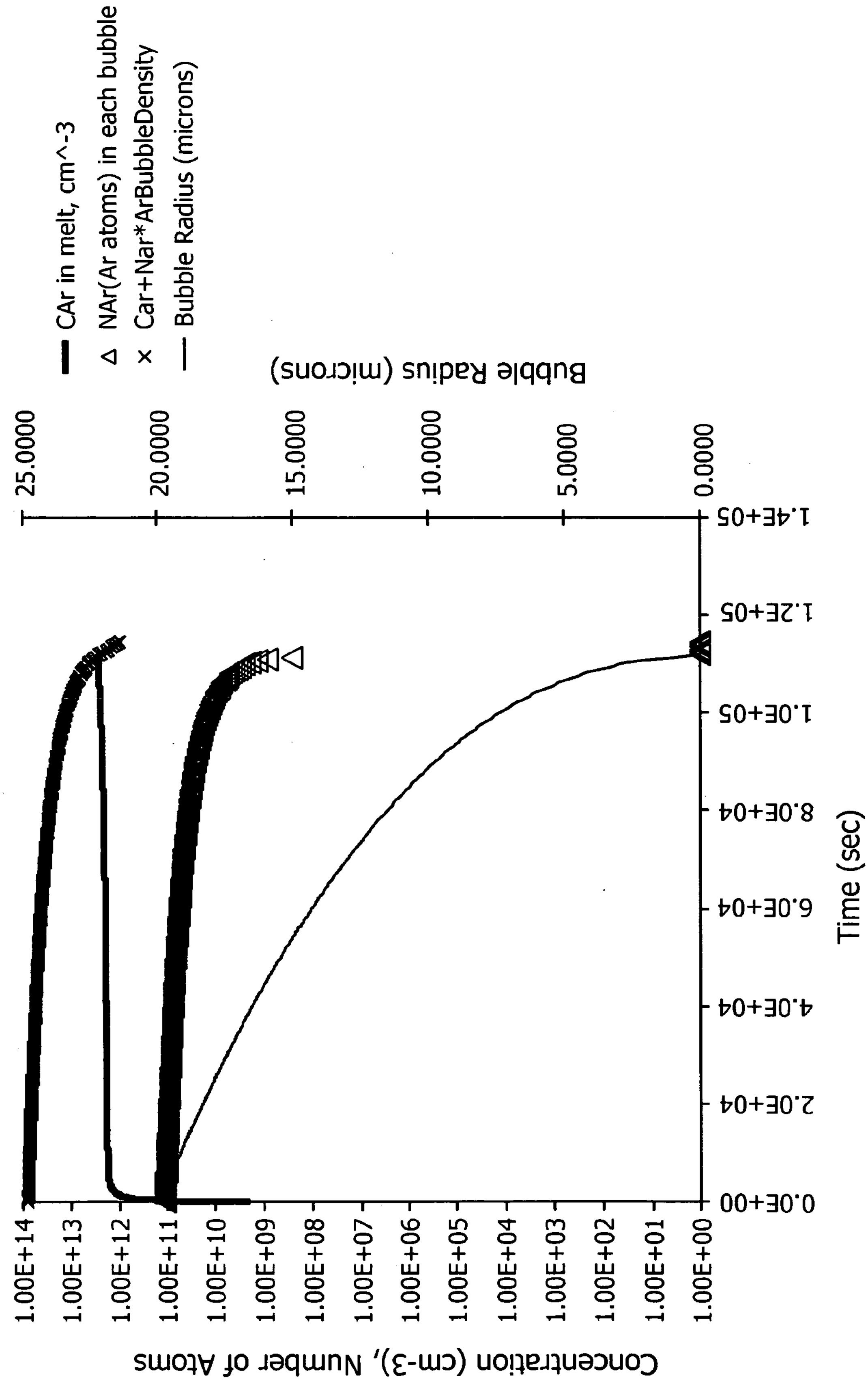

CAr in melt, cm^-3
NAr(Ar atoms) in each bubble
Car+Nar*ArBubbleDensity
Bubble Radius (microns)
Bubble Radius (microns)
25.0000
20.0000
15.0000
10.0000
5.0000
0.0000
Concentration (cm-3), Number of Atoms
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
Time (sec)
0.0E+00
2.0E+04
4.0E+04
6.0E+04
8.0E+04
1.0E+05
1.2E+05
1.4E+05

FIG. 9

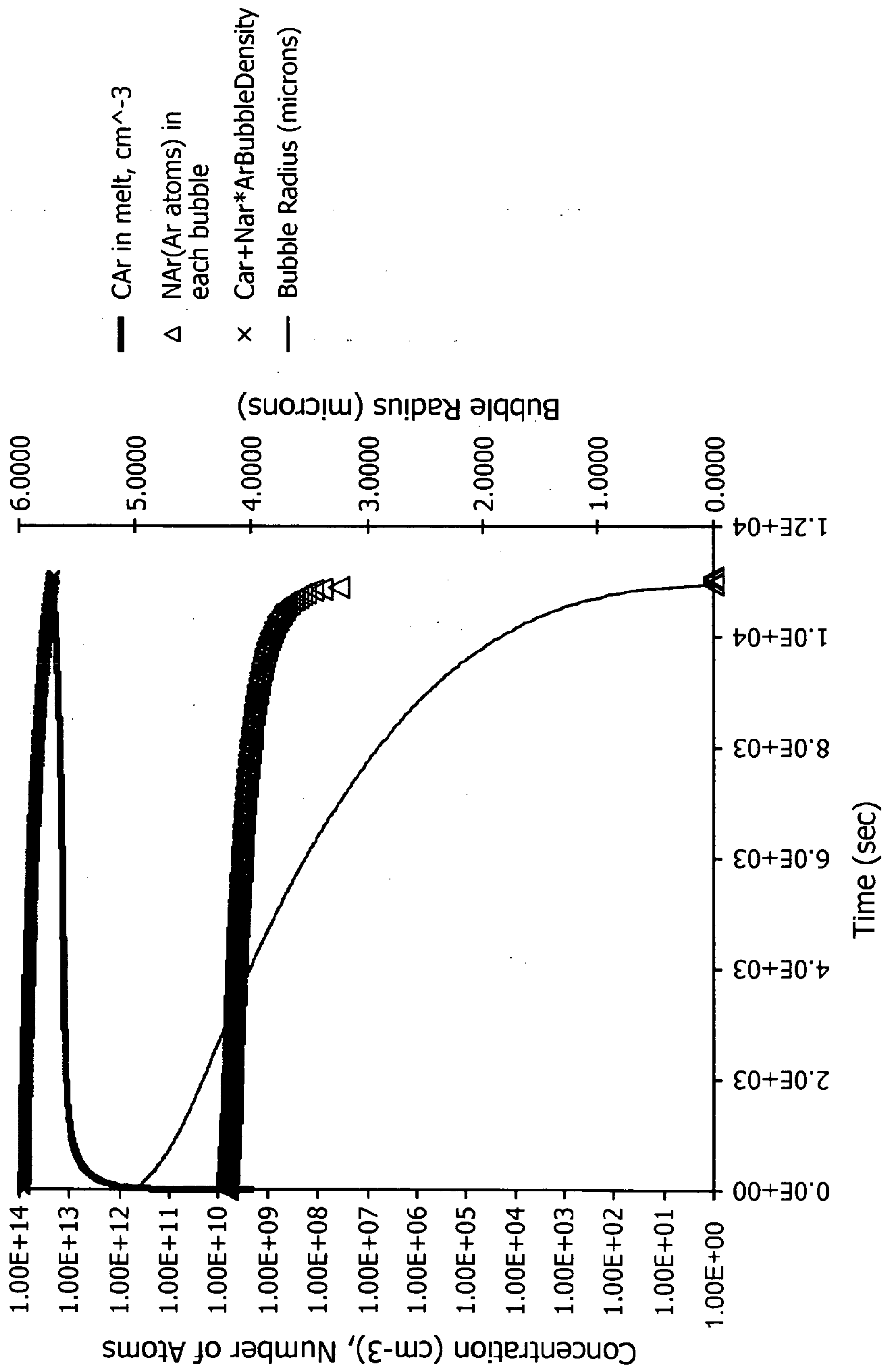
CAr in melt, cm^-3
NAr(Ar atoms) in each bubble
Car+Nar*ArBubbleDensity
Bubble Radius (microns)
Concentration (cm-3), Number of Atoms
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
Bubble Radius (microns)
6.0000
5.0000
4.0000
3.0000
2.0000
1.0000
0.0000
Time (sec)
0.0E+00
2.0E+03
4.0E+03
6.0E+03
8.0E+03
1.0E+04
1.2E+04

FIG. 10

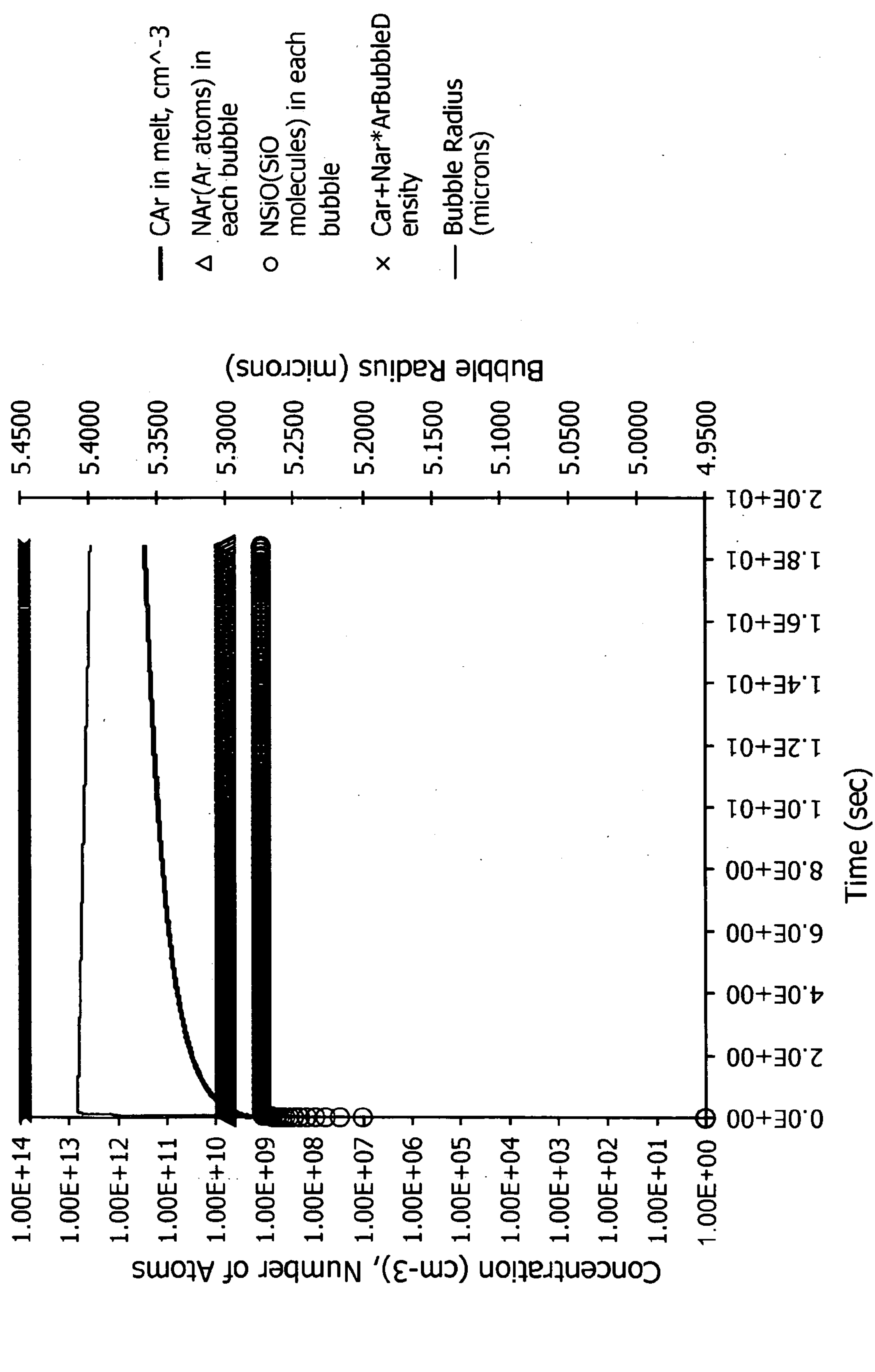

CAr in melt, cm^-3
NAr(Ar atoms) in each bubble
NSiO(SiO molecules) in each bubble
Car+Nar*ArBubbleDensity
Bubble Radius (microns)
Bubble Radius (microns)
5.4500
5.4000
5.3500
5.3000
5.2500
5.2000
5.1500
5.1000
5.0500
5.0000
4.9500
Concentration (cm-3), Number of Atoms
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
Time (sec)
0.0E+00
2.0E+00
4.0E+00
6.0E+00
8.0E+00
1.0E+01
1.2E+01
1.4E+01
1.6E+01
1.8E+01
2.0E+01

FIG. 11

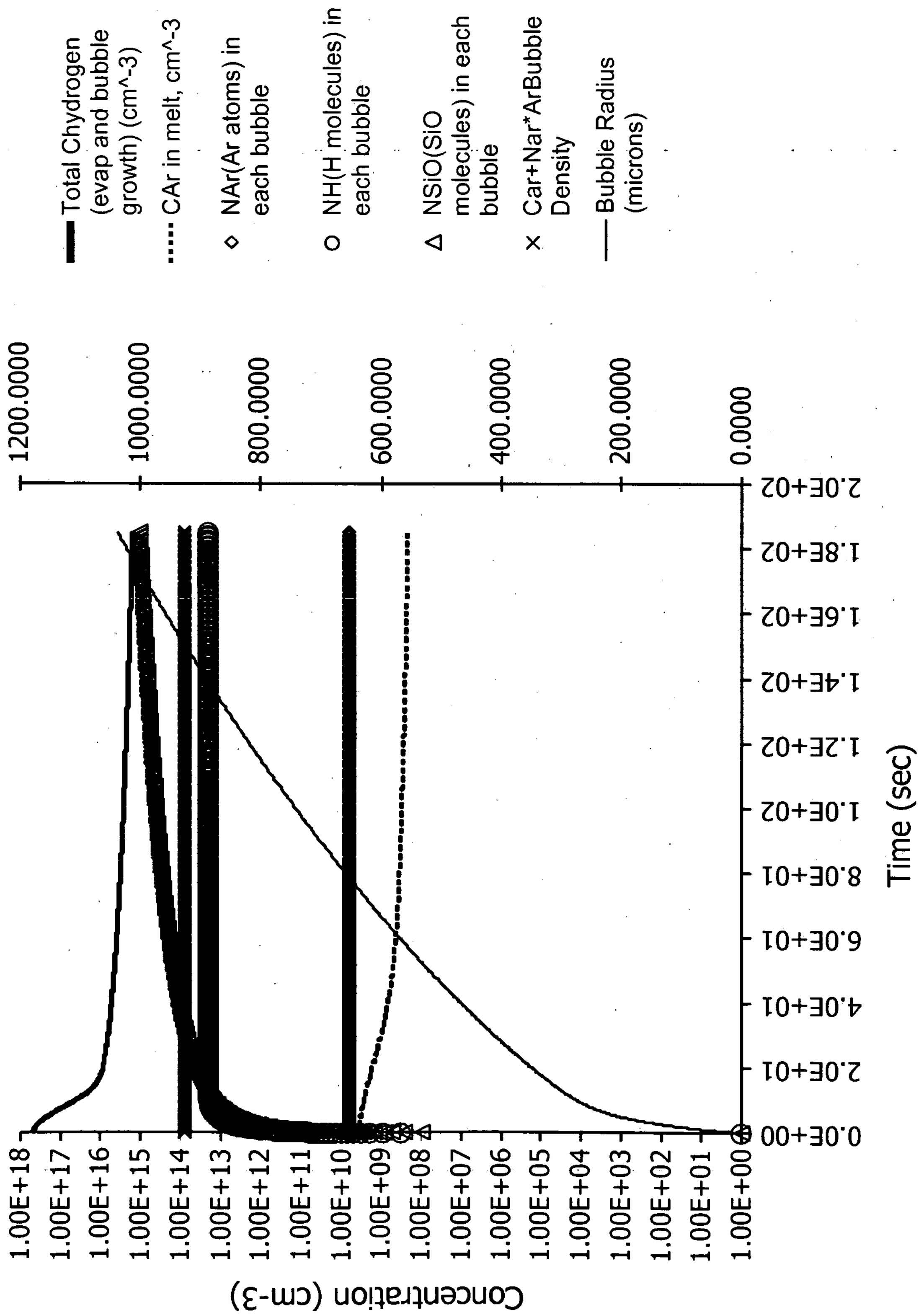

Concentration (cm-3)
1.00E+18
1.00E+17
1.00E+16
1.00E+15
1.00E+14
1.00E+13
1.00E+12
1.00E+11
1.00E+10
1.00E+09
1.00E+08
1.00E+07
1.00E+06
1.00E+05
1.00E+04
1.00E+03
1.00E+02
1.00E+01
1.00E+00
0.0E+00
2.0E+01
4.0E+01
6.0E+01
8.0E+01
1.0E+02
1.2E+02
1.4E+02
1.6E+02
1.8E+02
2.0E+02
Time (sec)
1200.0000
1000.0000
800.0000
600.0000
400.0000
200.0000
0.0000
Total Chydrogen (evap and bubble growth) (cm^-3)
CAr in melt, cm^-3
NAr(Ar atoms) in each bubble
NH(H molecules) in each bubble
NSiO(SiO molecules) in each bubble
Car+Nar*ArBubble Density
Bubble Radius (microns)

FIG. 12

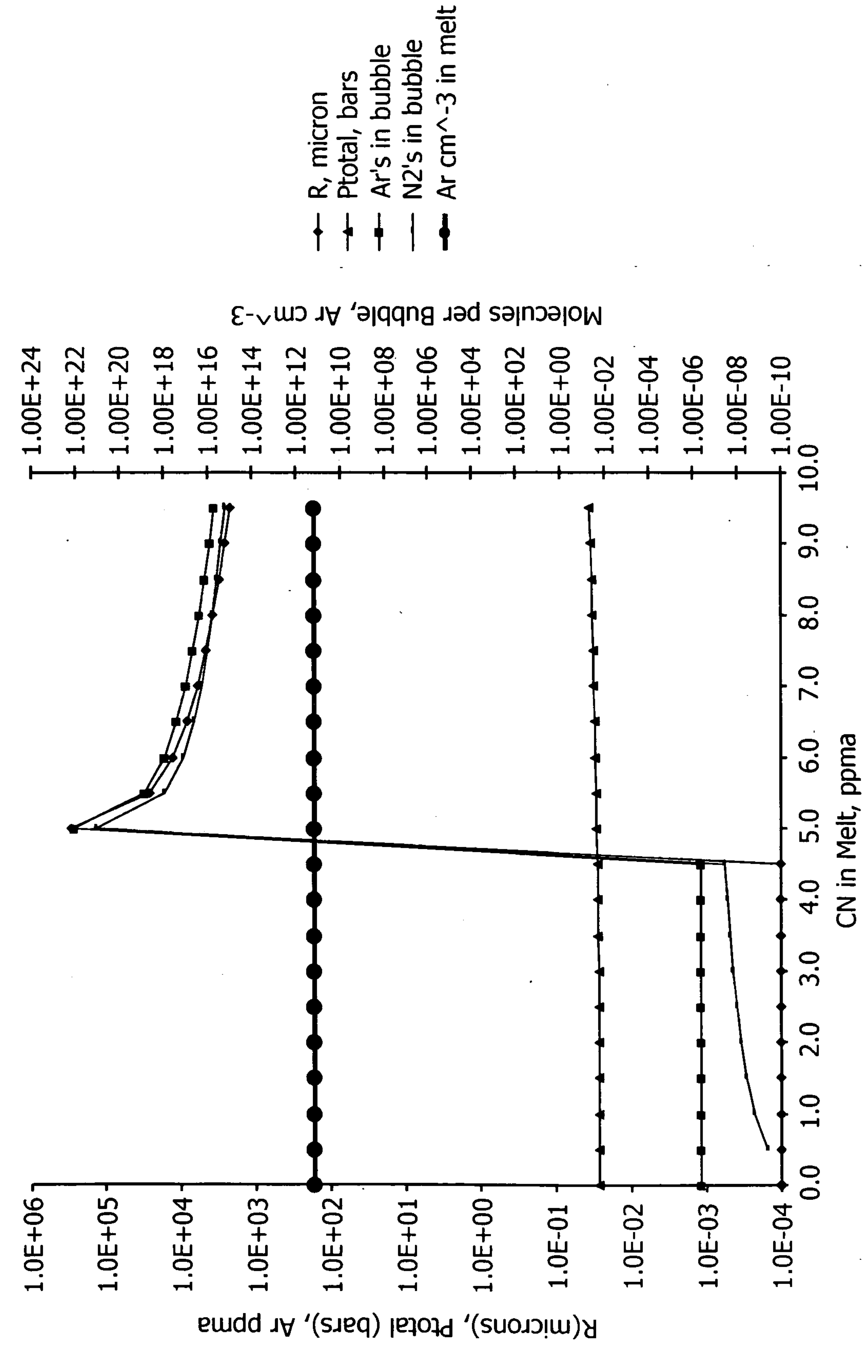
R(microns), Ptotal (bars), Ar ppma
1.0E+06
1.0E+05
1.0E+04
1.0E+03
1.0E+02
1.0E+01
1.0E+00
1.0E-01
1.0E-02
1.0E-03
1.0E-04
0.0
1.0
2.0
3.0
4.0
5.0
6.0
7.0
8.0
9.0
10.0
CN in Melt, ppma
Molecules per Bubble, Ar cm^-3
1.00E+24
1.00E+22
1.00E+20
1.00E+18
1.00E+16
1.00E+14
1.00E+12
1.00E+10
1.00E+08
1.00E+06
1.00E+04
1.00E+02
1.00E+00
1.00E-02
1.00E-04
1.00E-06
1.00E-08
1.00E-10
R, micron
Ptotal, bars
Ar's in bubble
N2's in bubble
Ar cm^-3 in melt

FIG. 13

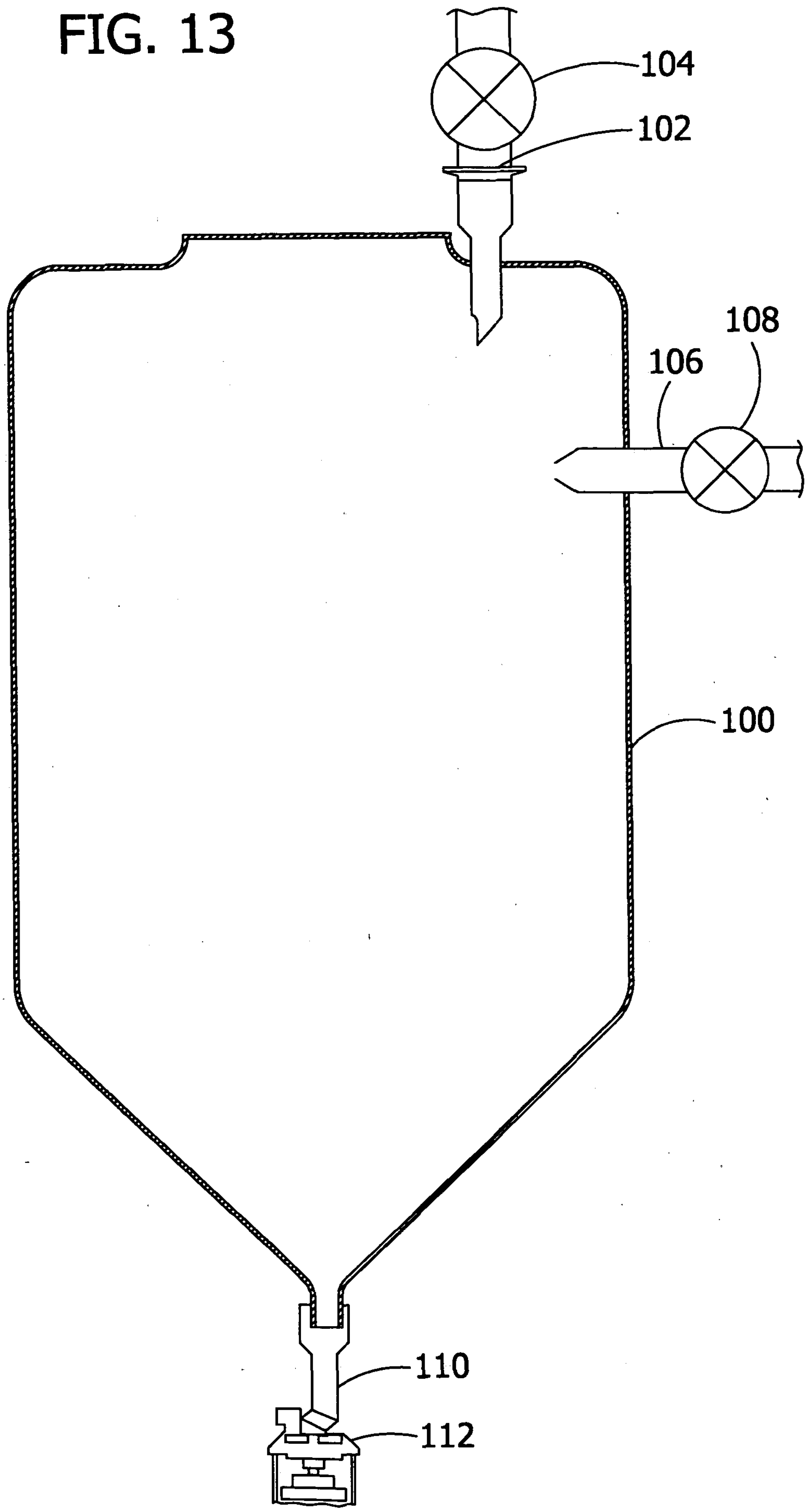

FIG. 14

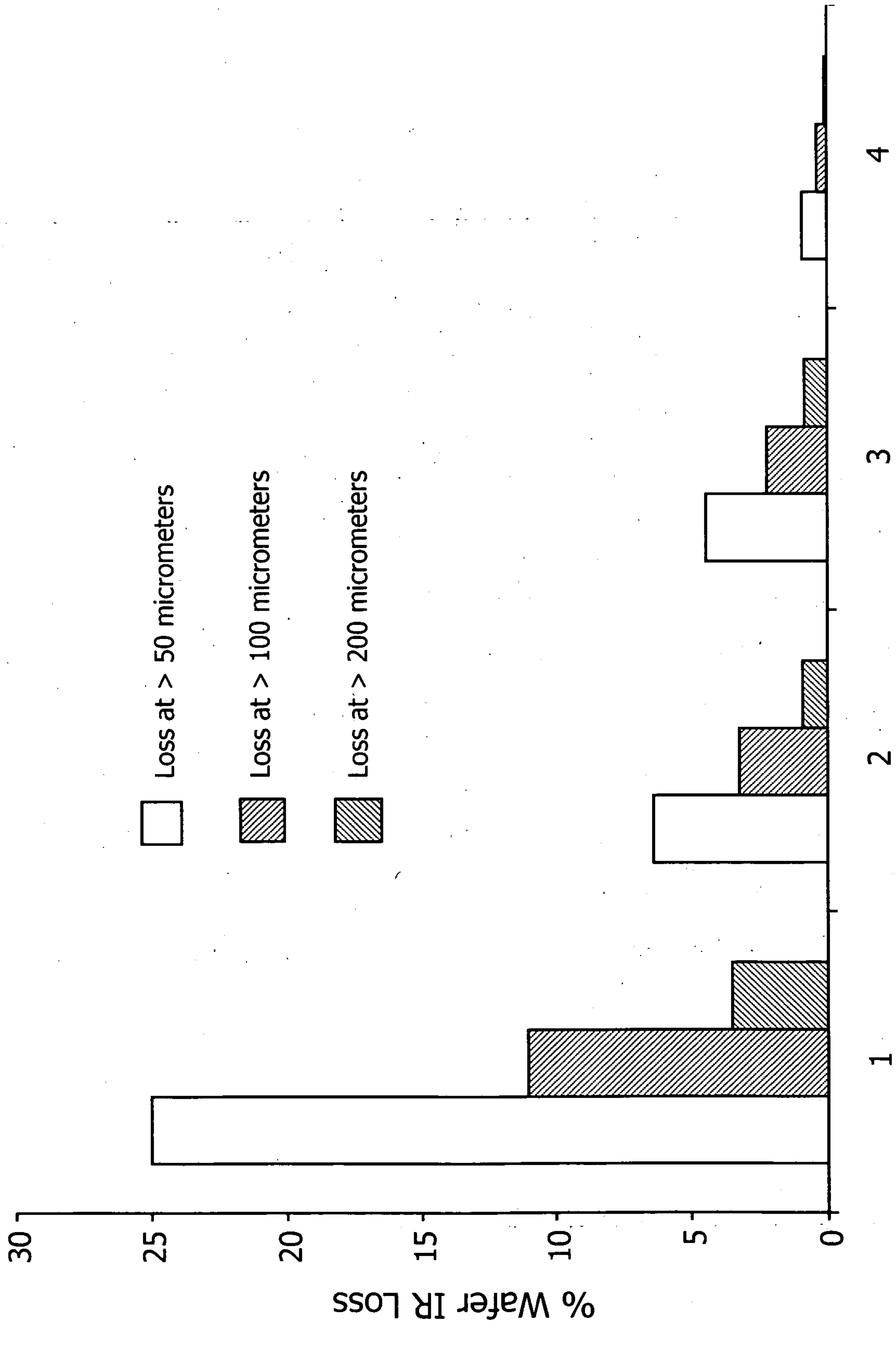

Loss at > 50 micrometers
Loss at > 100 micrometers
Loss at > 200 micrometers
% Wafer IR Loss
30
25
20
15
10
5
0
1
2
3
4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6344083 B
- WO 2004005591 A
- US 6461427 B
- US 6350312 B
- US 20030101924 A
- US 5588993 A